# EUROPEAN PATENT SPECIFICATION

(11) **EP 4 721 054 B1**
(45) Date of publication and mention of the grant of the patent: **09.12.2026**
(21) Application number: 24725897.3
(22) Date of filing: 16.05.2024
(51) Int. Cl.: G10L 21/02, H03G 5/16, H04R 1/40, G10L 21/0272, G10L 21/0216, G10L 25/18, H04R 3/00

(54) **BEAMFORMING-DEPENDENT ADAPTATION OF FREQUENCY EQUALIZATION**
STRAHLFORMUNGSABHÄNGIGE ANPASSUNG DER FREQUENZAUSGLEICHUNG
ADAPTATION DE L'ÉGALISATION DE FRÉQUENCE DÉPENDANTE DE LA FORMATION DE FAISCEAU

(30) Priority: 30.05.2023 EP 23176036
(43) Date of publication of application: 08.04.2026
(73) Proprietor: Koninklijke Philips N.V., 5656 AE Eindhoven (NL)
(72) Inventor: JANSE, Cornelis Pieter, 5656 AG Eindhoven (NL); BLOEMENDAL, Brian Brand Antonius Johannes, 5656 AG Eindhoven (NL); JANSSEN, Rik Jozef Martinus, 5656 AG Eindhoven (NL)
(74) Representative: Philips Intellectual Property & Standards
(86) International application number: PCT/EP2024/063461
(87) International publication number: WO 2024/245762

(56) References cited:
- EP-A1- 2 551 850
- US-B1- 7 146 012
- GOMEZ RANDY ET AL: "Dereverberation robust to speaker's azimuthal orientation in multi-channel human-robot communication", 2013 IEEE/RSJ INTERNATIONAL CONFERENCE ON INTELLIGENT ROBOTS AND SYSTEMS(ROS), IEEE, 3 November 2013 (2013-11-03), pages 3439 - 3444, XP032537672, ISSN: 2153-0858, [retrieved on 20131227], DOI: 10.1109/IROS.2013.6696846
- INES HAFIZOVIC ET AL: "Decorrelation for adaptive beamforming applied to arbitrarily sampled spherical microphone arrays", APPLICATIONS OF SIGNAL PROCESSING TO AUDIO AND ACOUSTICS (WASPAA), 2011 IEEE WORKSHOP ON, IEEE, 16 October 2011 (2011-10-16), pages 233 - 236, XP032011509, ISBN: 978-1-4577-0692-9, DOI: 10.1109/ASPAA.2011.6082300

## Description

### FIELD OF THE INVENTION

The invention relates to an apparatus and a method for generating an audio output signal, and in particular, but not exclusively, to extracting audio from a wanted audio source, such as a desired speaker, using beamforming.

### BACKGROUND OF THE INVENTION

Capturing audio, and in particularly speech, has become increasingly important in the last decades. For example, capturing speech or other audio has become increasingly important for a variety of applications including telecommunication, teleconferencing, gaming, audio user interfaces, etc. However, a problem in many scenarios and applications is that the desired audio source is typically not the only audio source in the environment. Rather, in typical audio environments there are many other audio/noise sources which are being captured by the microphone. Audio processing is often used to improve the capture of audio, and in particular to post-process the captured audio time interval improves the resulting audio signals.

In many embodiments, audio may be represented by a plurality of different audio signals that reflect the same audio scene or environment. In particular, in many practical applications, audio is captured by a plurality of microphones at different positions. For example, a linear array of a plurality of microphones is often used to capture audio in an environment, such as in a room. The use of multiple microphones allows spatial information of the audio to be captured. Many different applications may exploit such spatial information allowing improved and/or new services.

One frequently used approach is to try to separate audio sources by applying beamforming to form beams directed towards the direction of arrival of audio from specific audio sources. However, although this may provide advantageous performance in many scenarios, it is not optimal in all cases. For example, it may not provide optimal source separation in some cases, and indeed in some applications such a spatial beamforming may not provide audio properties that are ideal for further processing to achieve a given effect.

Thus, whereas spatial audio source separation, and specifically such separation based on audio beamforming, is highly advantageous in many scenarios and applications, there is a desire to improve the performance and operation of such approaches. However, there is typically also a desire for low complexity and/or resource usage (e.g. computational resources) and often these preferences conflict with each other.

Hence, an improved approach would be advantageous, and in particular an approach allowing reduced complexity, increased flexibility, facilitated implementation, reduced cost, improved audio capture, improved differentiation of audio sources, improved audio source separation, improved audio/speech application support, reduced dependency on known or static acoustic properties, improved flexibility and customization to different audio environments and scenarios, improved audio beamforming, an improved trade-off between performance and complexity/ resource usage, and/or improved performance would be advantageous.

A prior art approach is described in GOMEZ RANDY ET AL: "Dereverberation robust to speaker's azimuthal orientation in multi-channel human-robot communication", 2013 IEEE/RSJ INTERNATIONAL CONFERENCE ON INTELLIGENT ROBOTS AND SYSTEMS(ROS), IEEE, 3 November 2013 (2013-11-03), pages 3439-3444.

### SUMMARY OF THE INVENTION

Accordingly, the invention seeks to preferably mitigate, alleviate or eliminate one or more of the above mentioned disadvantages singly or in any combination.

According to an aspect of the invention there is provided an audio apparatus comprising: a receiver arranged to receive a first set of audio signals, the first set of audio signals comprising audio signals capturing audio of a scene from different positions; an audio beamformer arranged to generate a beamform output audio signal from the first set of audio signals, the audio beamformer comprising: a signal processor arranged to generate the beamform output audio signal from a signal processing of the first set of audio signals, the signal processing including spatial beamforming and spatial decorrelation for the first set of audio signals, the spatial decorrelation depending on a set of decorrelation parameters and the spatial beamforming depending on a set of beamform parameters, the beamforming including a combination of audio signals, the combination generating the beamform output audio signal and including at least one of a filtering and a weighting of the audio signals, the beamform parameters being parameters describing at least one of the filtering and the weighting of audio signals of the combination; a beamform adapter arranged to adapt the set of beamform parameters dependent on the beamform output audio signal; an equalizer arranged to apply a frequency equalization to the beamform output audio signal to generate an output signal; and an equalization adapter arranged to adapt the frequency equalization dependent on the set of beamform parameters.

The approach may provide improved operation and/or performance in many embodiments. It may in particular allow improved beamforming to focus on a specific audio source in the scene. It may allow improved extraction/separation of audio from a specific source in the presence of other audio and noise sources in the scene.

The approach may allow the operation of the audio apparatus to effectively adapt to the current conditions, and in particular the acoustic and spatial properties of the audio sources and the scene. It may provide reduced sensitivity to noise and unwanted audio sources in the scene and captured audio.

The approach may allow efficient operation and low complexity in many embodiments. The different adaptations may synergistically interwork to provide improved separation of a desired audio source from other captured audio of the scene. Further, the use of multiple adaptations may provide an improved operation while allowing lower complexity adaptation algorithms and criteria to be used.

The approach may provide a higher quality output audio signal. In many embodiments, the approach may reduce or mitigate frequency distortion. The approach may result in a more naturally sounding capture of a desired audio source. Higher captured audio fidelity may be achieved in many embodiments.

The equalizer may be arranged to apply a frequency equalization to the beamform output audio signal by applying a frequency response. The equalizer may be arranged to apply a frequency equalization to the beamform output audio signal by filtering the beamform output audio signal having a non-constant magnitude frequency response. The equalization adapter may be arranged to adapt the frequency response.

In accordance with an optional feature of the invention, the equalization adapter is arranged to adapt the frequency equalization dependent on the set of decorrelation parameters.

This may provide improved performance and/or operation in many embodiments. It may in particular, in many embodiments generate an output audio signal more accurately capturing a desired audio source in the audio scene. It may in many scenarios allow an improved adaptation of the frequency equalization, resulting in reduced frequency distortion.

In accordance with an optional feature of the invention, the signal processor comprises: a spatial decorrelator arranged to receive the first set of audio signals and to generate a decorrelated first set of audio signals by performing the spatial decorrelation; and a beamform circuit arranged to perform the spatial beamforming by combining the decorrelated first set of audio signals, the combining depending on the set of beamform parameters.

This may provide improved performance and/or operation in many embodiments. It may in many embodiments provide particularly accurate sound capture while facilitating implementation and maintaining low complexity.

In accordance with an optional feature of the invention, the equalization adapter is arranged to adapt the frequency equalization to have a minimum phase frequency response.

This may provide improved performance and/or operation in many embodiments. In accordance with an optional feature of the invention, the equalization adapter is arranged to adapt the frequency equalization to have a low pass frequency response.

This may provide improved performance and/or operation in many embodiments. It may in particular, in many embodiments generate an output audio signal more accurately capturing a desired audio source in the audio scene. It may in many scenarios allow an improved adaptation of the frequency equalization, resulting in reduced frequency distortion.

In accordance with an optional feature of the invention, the equalization adapter is arranged to transition from a first frequency equalization to a second frequency equalization by determining first intermediate samples of the output signal for the first frequency equalization and second intermediate samples of the output signal for the second frequency equalization, and generating samples of the output signal as a weighted combination of the first intermediate samples and the second intermediate samples, the equalization adapter being arranged to gradually change the relative weighting of the first intermediate samples and the second intermediate samples during a transition time interval.

This may provide improved performance and/or operation in many embodiments. It may in many scenarios reduce audio artefacts.

In accordance with an optional feature of the invention, the spatial decorrelation is an adaptive spatial decorrelation and the audio apparatus further comprises: a decorrelation adapter arranged to adapt the set of decorrelation parameters dependent on the first set of audio signals.

This may provide improved performance and/or operation in many embodiments.

In accordance with an optional feature of the invention, the audio apparatus further comprises an audio detector arranged to determine a set of active time intervals during which an audio source is active and a set of inactive time intervals during which the audio source is not active; and wherein at least one of the adaption of the set of beamform parameters and the adaptation of the set of decorrelation coefficients is different for the set of active time intervals and the set of inactive time intervals.

This may provide improved performance and/or operation in many embodiments. It may typically provide improved adaptation which typically may lead to improved extraction of a desired audio source.

The active time intervals may be desired/wanted/speech audio source active time intervals and the inactive time intervals may be desired/wanted/speech audio source inactive time intervals.

In some embodiments, the beamform adapter is arranged to adapt the first set of filters and the second set of filters with a higher rate of adaptation during the set of active time intervals than during the set of inactive time intervals.

This may provide improved performance and/or operation in many embodiments. It may typically provide improved adaptation which typically may lead to improved extraction of a desired audio source.

In some embodiments, the beamform adapter is arranged to adapt the first set of filters and the second set of filters during only one set of time intervals of the set of active time intervals and the set of inactive time intervals.

This may provide improved performance and/or operation in many embodiments. It may typically provide improved adaptation which typically may lead to improved extraction of a desired audio source.

In some embodiments, the beamform adapter is arranged to adapt the first set of filters and the second set of filters during the set of active time intervals but not during the set of inactive time intervals.

In some embodiments, the decorrelation adapter is arranged to adapt the decorrelation coefficients with a higher rate of adaptation during the set of inactive time intervals than during the set of active time intervals.

This may provide improved performance and/or operation in many embodiments. It may typically provide improved adaptation which typically may lead to improved extraction of a desired audio source.

In some embodiments, the decorrelation adapter is arranged to adapt the decorrelation coefficients during only one set of time intervals of the set of inactive time intervals and the set of active time intervals.

This may provide improved performance and/or operation in many embodiments. It may typically provide improved adaptation which typically may lead to improved extraction of a desired audio source.

In some embodiments, the adaptive coefficient processor is arranged to adapt the decorrelation coefficients during the set of inactive time intervals but not during the set of active time intervals.

In accordance with an optional feature of the invention, the signal processor comprises: a first set of filters arranged to filter the first set of audio signals, and a combiner arranged to combine outputs of the first set of filters to generate the beamform output audio signal; a feedback circuit comprising a second set of filters arranged to generate a second set of audio signals from a filtering of the beamform output audio signal, each filter of the second set of filters having a frequency response being a complex conjugate of a filter of the first set of filters; a first set of spatial filters arranged to apply a first spatial filtering to at least one of the first set of audio signals and the second set of audio signals, the first set of spatial filters having coefficients determined from decorrelation coefficients comprised in the decorrelation parameters; and wherein the beamform adapter is arranged to adapt the first set of filters and the second set of filters in response to a comparison of the first set of audio signals and the second set of audio signals; and the decorrelation adapter is arranged to determine decorrelation coefficients for a set of spatial decorrelation filters generating decorrelated output signals from the first set of audio signals, the decorrelation adapter being arranged to adapt the decorrelation coefficients in response to an update value determined from the first set of audio signals.

This may provide improved performance and/or operation in many embodiments. It may provide a particularly advantageous beamforming for the specific approach and may interwork efficiently with the spatial decorrelation and the equalization.

Each filter of the first set of filters is linked with a filter of the second set of filters with this filter having a frequency response being a complex conjugate of the frequency response of the filter of the first set of filters.

The first and second set of filters may have an equal number of linked paired filters having complex conjugate frequency responses. For each audio signal in the first set of audio signals there may be one filter of the first set of filters, one linked/paired filter in the second set of filters (with a complex conjugate frequency response), and one audio signal in the second set of audio signals. The comparison may be a comparison between linked/paired audio signals of the first set of audio signals and the second set of audio signals. The adaptation of a given filter of the first set of filters and a given linked filter of the second set of filters may be in response/dependence on (possibly only) a comparison of a signal of the first set of audio signals filtered by the given filter of the first set of filters and a signal of the second set of audio signals generated by filtering of the beamform output audio signal by the given linked filter of the second set of filters. The adaptation may be such that the difference is reduced.

Each of the second set of audio signals may be an estimate of the contribution to the linked audio signal of the first set of audio signals from the audio captured by the beamform output audio signal, and thus typically may be an estimate of the contribution from a wanted/desired source.

The set of spatial decorrelation filters may include one spatial filter for each signal of the first set of signals. Each filter of the set of spatial decorrelation filters may generate a filtered/modified version of one audio signal of the first set of audio signals. The set of spatial decorrelation filters may together generate a modified first set of audio signals with a higher degree of decorrelation. The spatial decorrelation filters may perform filtering over the first set of audio signals. The output of a decorrelation filter (the corresponding modified audio signal of the first set of audio signals) may be dependent on a plurality of the (unmodified) first set of audio signals. The spatial decorrelation filters may specifically be frequency domain filters and the decorrelation coefficients may be frequency domain coefficients. For a given spatial decorrelation filter, the output value for a given frequency bin at a given time may be a weighted combination of a plurality of values of the (unmodified) first set of audio signals for the given frequency bin at the given time. The decorrelated output signals may have a reduced normalized cross channel signal correlation with respect to the first set of input signals to the set of spatial decorrelation filters.

The set of spatial filters may include one spatial filter for each signal of the first set of signals/ second set of signals. Each filter of the set of spatial filters may generate a filtered/modified version of one audio signal of the first or second set of audio signals. The set of spatial filters may together generate a modified first or second set of audio signals. The spatial filters may perform filtering over the first set of audio signals. The output of a spatial filter (the corresponding modified audio signal of the first or second set of audio signals) may be dependent on a plurality of the (unmodified) first or second set of audio signals. The spatial filters may specifically be frequency domain filters and the coefficients may be frequency domain coefficients. For a given spatial filter, the output value for a given frequency bin at a given time may be a weighted combination of a plurality of values of the (unmodified) first or second set of audio signals for the given frequency bin at the given time.

In accordance with an optional feature of the invention, the first set of spatial filters is arranged to filter the first set of audio signals.

This may provide improved performance and/or operation in many embodiments. In many embodiments and scenarios, this may provide particularly attractive performance and/or implementation.

In some embodiments, the first set of spatial filters is arranged to have coefficients set to the decorrelation coefficients determined for the set of spatial decorrelation filters.

This may provide improved performance and/or operation in many embodiments. In many embodiments and scenarios, this may provide particularly attractive performance and/or implementation.

In accordance with an optional feature of the invention, the first set of filters is arranged to filter the first set of audio signals after filtering by the first set of spatial filters and the beamform adapter is arranged to perform the comparison using the first set of audio signals before filtering by the first set of spatial filters.

This may provide improved performance and/or operation in many embodiments. In many embodiments and scenarios, this may provide particularly attractive performance and/or implementation.

In some embodiments, the first set of spatial filters is arranged to have coefficients matching coefficients of a spatial filter being a cascade of two of the set of decorrelation filters.

This may provide improved performance and/or operation in many embodiments. In many embodiments and scenarios, this may provide particularly attractive performance and/or implementation.

In accordance with an optional feature of the invention, the first set of spatial filters is arranged to filter the second set of audio signals.

This may provide improved performance and/or operation in many embodiments. In many embodiments and scenarios, this may provide particularly attractive performance and/or implementation.

In some embodiments, the first set of spatial filters is arranged to have coefficients determined in response to a set of inverse spatial decorrelation filters, the set of inverse spatial decorrelation filters being inverse filters of the set of spatial decorrelation filters.

This may provide improved performance and/or operation in many embodiments. In many embodiments and scenarios, this may provide particularly attractive performance and/or implementation.

In some embodiments, the first set of spatial filters is arranged to have coefficients matching coefficients of a spatial filter being a cascade of two sets of spatial inverse filters each of which comprises inverse filters of the set of spatial decorrelation filters.

This may provide improved performance and/or operation in many embodiments. In many embodiments and scenarios, this may provide particularly attractive performance and/or implementation.

In accordance with an optional feature of the invention, the decorrelation adapter is arranged to determine the adaptive spatial decorrelation as a set of spatial decorrelation filters, each output audio signal of a filter of the set of spatial decorrelation filters being linked with one input audio signal of the first set of audio signals, by performing the steps of: segmenting the first set of audio signals into time segments, and for at least some time segments performing the steps of: generating a frequency bin representation of the first set of audio signals, each frequency bin of the frequency bin representation of the first set of audio signals comprising a frequency bin value for each of the audio signals of the first set of audio signals; generating a frequency bin representation of a set of output signals, each frequency bin of the frequency bin representation of the set of output signals comprising a frequency bin value for each of the output signals, the frequency bin value for a given output signal of the set of output signals for a given frequency bin being generated as a weighted combination of frequency bin values of the first set of audio signals for the given frequency bin, the weighted combination having the decorrelation coefficients as weights; updating a first weight for a contribution to a first frequency bin value of a first frequency bin for a first output signal linked with a first input audio signal from a second frequency bin value of the first frequency bin for a second input audio signal linked to a second output signal in response to a correlation measure between a first previous frequency bin value of the first output signal for the first frequency bin and a second previous frequency bin value of the second output signal for the first frequency bin.

This may provide improved performance and/or operation in many embodiments. In many embodiments and scenarios, this may provide particularly attractive performance and/or implementation.

This may provide an advantageous generation of output audio signals with typically increased decorrelation in comparison to the input signals. The approach may provide an efficient adaptation of the operation resulting in improved decorrelation in many embodiments. The adaptation may typically be implemented with low complexity and/or resource usage. The approach may specifically apply a local adaptation of individual weights yet achieve an efficient global adaptation.

The generation of the set of output signals may be adapted to provide increased decorrelation relative to the input signals which in many embodiments and for many applications may provide improved audio processing and in particular beamforming.

The first and second output audio signals may typically be different output audio signals.

In accordance with an optional feature of the invention, the decorrelation adapter is arranged to update the first weight in response to a product of a first value and a second value, the first value being one of the first previous frequency bin value and the second previous frequency bin value and the second value being a complex conjugate of the other of the first previous frequency bin value and the second previous frequency bin value.

This may provide improved performance and/or operation in many embodiments. It may typically provide improved adaptation leading to increased decorrelation of the output audio signals in many scenarios.

In some embodiments, the audio apparatus may be arranged to update a second weight being for a contribution to the first frequency bin value from a third frequency bin value being a frequency bin value of the first frequency bin for the first input audio signal in response to a magnitude of the first previous frequency bin value.

This may provide improved performance and/or operation in many embodiments. It may typically provide improved adaptation leading to increased decorrelation of the output audio signals in many scenarios. It may in particular provide an improved adaptation of the generated output signals. In many embodiments, the updating of the weight reflecting the contribution to an output signal from the linked input signal may be dependent on the signal magnitude/amplitude of that linked input signal. For example, the updating may seek to compensate the weight for the level of the input signal to generate a normalized output signal.

The approach may allow a normalization/ signal compensation/level compensation to provide e.g., a desired output level.

In some embodiments, the audio apparatus may be arranged to set a weight for a contribution to the first frequency bin value from a third frequency bin value being a frequency bin value of the first frequency bin for the first input audio signal to a predetermined value.

This may provide improved performance and/or operation in many embodiments. It may typically provide improved adaptation leading to increased decorrelation of the output audio signals in many scenarios. It may in many embodiments provide improved adaptation while ensuring convergence of the adaptation towards a non-zero signal level. It may interwork very efficiently with the adaptation of weights that are not for linked signal pairs.

In many embodiments, the adapter may be arranged to keep the weight constant and with no adaptation or updating of the weight.

In some embodiments, the audio apparatus may be arranged to constrain a weight for a contribution to the first frequency bin value from a third frequency bin value being a frequency bin value of the first frequency bin for the first input audio signal to be a real value.

This may provide improved performance and/or operation in many embodiments. It may typically provide improved adaptation leading to increased decorrelation of the output audio signals in many scenarios.

The weights between linked input/output signals may advantageously be determined as/ constrained to be a real valued weight. This may lead to improved performance and adaptation ensuring convergence on a non-zero level solution.

In some embodiments, the audio apparatus may be arranged to set a second weight being a weight for a contribution to a fourth frequency bin value of the first frequency bin for the second output audio signal from the first input audio signal to be a complex conjugate of the first weight.

This may provide improved performance and/or operation in many embodiments. It may typically provide improved adaptation leading to increased decorrelation of the output audio signals in many scenarios.

The two weights for two pairs of input/output signals may be complex conjugates of each other in many embodiments.

In some embodiments, weights of the weighted combination for other input audio signals than the first input audio signal are complex valued weights.

This may provide improved performance and/or operation in many embodiments. The use of complex values for weights for non-linked input signals provide an improved frequency domain operation.

In some embodiments, the audio apparatus may be arranged to determine output bin values for the given frequency bin ω from: $y \left(ω\right) = W \left(ω\right) x \left(ω\right)$ where ***y***(ω) is a vector comprising the frequency bin values for the output audio signals for the given frequency bin ω; **x**(ω) is a vector comprising the frequency bin values for the input audio signals for the given frequency bin ω; and **W**(ω) is a matrix having rows comprising weights of a weighted combination for the output audio signals.

This may provide improved performance and/or operation in many embodiments. It may typically provide improved adaptation leading to increased decorrelation of the output audio signals in many scenarios.

The matrix **W**(ω) may advantageously be Hermitian. In many embodiments, the diagonal of the matrix **W**(ω) may be constrained to be real values, may be set to a predetermined value(s), and/or may not be updated/adapted but may be maintained as a fixed value. The weights/coefficients outside the diagonal may generally be complex values.

In some embodiments, the audio apparatus may be arranged to adapt weights wᵢⱼ of the matrix **W**(ω) according to: ${w}_{ij} \left(k+1,ω\right) = {w}_{ij} \left(k, ω\right) - η \left(k, ω\right) \left[{y}_{i}\left(k, ω\right){ y}_{j}^{*}\left(k, ω\right)\right]$ where i is a row index of the matrix **W**(ω) , j is a column index of the matrix **W**(ω) , k is a time segment index, ω represents the frequency bin, and η (k, ω ) is a scaling parameter for adapting an adaptation speed.

This may provide improved performance and/or operation in many embodiments. It may typically provide improved adaptation leading to increased decorrelation of the output audio signals in many scenarios.

In some embodiments, the audio apparatus may be arranged to compensate the correlation value for a signal level of the first frequency bin.

This may provide improved performance and/or operation in many embodiments. It may typically provide improved adaptation leading to increased decorrelation of the output audio signals in many scenarios. It may allow a compensation of the update rate for signal variations.

In some embodiments, the audio apparatus may be arranged to initialize the weights for the weighted combination to comprise at least one zero value weight and one non-zero value weight.

This may provide improved performance and/or operation in many embodiments. It may typically provide improved adaptation leading to increased decorrelation of the output audio signals in many scenarios. It may allow a more efficient and/or quicker adaptation and convergence towards advantageous decorrelation. In many embodiments, the matrix **W**(ω) may be initialized with zero values for weights or coefficients for nonlinked signals and fixed non-zero real values for linked signals. Typically, the weights may be set to e.g., 1 for weights on the diagonal and all other weights may initially be set to zero.

In some embodiments, the weighted combination comprises applying a time domain windowing to a frequency representation of weights formed by weights for the first input audio signal and the second input audio signal for different frequency bins.

This may provide improved performance and/or operation in many embodiments. It may typically provide improved adaptation leading to increased decorrelation of the output audio signals in many scenarios.

Applying the time domain windowing to the frequency representation of weights may comprise: converting the frequency representation of weights to a time domain representation of weights; applying a window to the time domain representation to generate a modified time domain representation; and converting the modified time domain representation to the frequency domain.

According to an aspect of the invention, there is provided a method of operation for an audio apparatus, the method comprising receiving a first set of audio signals, the first set of audio signals comprising audio signals capturing audio of a scene from different positions; generating a beamform output audio signal from the first set of audio signals, wherein generating the beamform output audio signal comprises: generating the beamform output audio signal from a signal processing of the first set of audio signals, the signal processing including spatial beamforming and adaptive spatial decorrelation for the first set of audio signals, the adaptive spatial decorrelation depending on a set of decorrelation parameters and the spatial beamforming depending on a set of beamform parameters, the beamforming including a combination of audio signals, the combination generating the beamform output audio signal and including at least one of a filtering and a weighting of the audio signals, the beamform parameters being parameters describing at least one of the filtering and the weighting of audio signals of the combination; adapting the set of decorrelation parameters dependent on the first set of audio signals; adapting the set of beamform parameters dependent on the beamform output audio signal; applying a frequency equalization to the beamform output audio signal to generate an output signal; and adapting the frequency equalization dependent on the set of beamform parameters.

These and other aspects, features and advantages of the invention will be apparent from and elucidated with reference to the embodiment(s) described hereinafter.

### BRIEF DESCRIPTION OF THE DRAWINGS

Embodiments of the invention will be described, by way of example only, with reference to the drawings, in which
FIG. 1 illustrates an example of elements of an audio apparatus in accordance with some embodiments of the invention;
FIG. 2 illustrates an example of elements of an audio beamformer for an audio apparatus in accordance with some embodiments of the invention;
FIG. 3 illustrates an example of elements of an audio beamformer for an audio apparatus in accordance with some embodiments of the invention;
FIG. 4 illustrates an example of elements of an audio beamformer for an audio apparatus in accordance with some embodiments of the invention;
FIG. 5 illustrates an example of elements of an audio beamformer for an audio apparatus in accordance with some embodiments of the invention;
FIG. 6 illustrates an example of elements of an audio beamformer for an audio apparatus in accordance with some embodiments of the invention;
FIG. 7 illustrates an example of elements of an audio beamformer for an audio apparatus in accordance with some embodiments of the invention;
FIG. 8 illustrates an example of elements of an audio beamformer for an audio apparatus in accordance with some embodiments of the invention; and
FIG. 9 illustrates some elements of a possible arrangement of a processor for implementing elements of an audio apparatus in accordance with some embodiments of the invention.

### DETAILED DESCRIPTION OF SOME EMBODIMENTS OF THE INVENTION

The following description focuses on embodiments of the invention applicable to audio capturing such as e.g., speech capturing for a teleconferencing apparatus. However, it will be appreciated that the approach is applicable to many other audio signals, audio processing systems, and scenarios for capturing and/or processing audio.

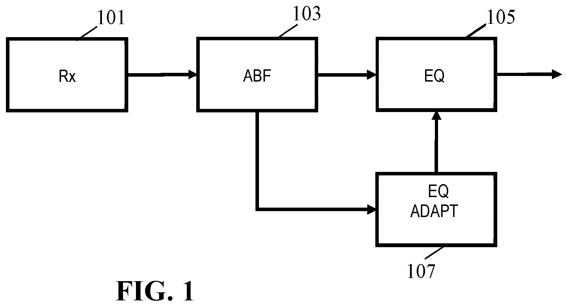

FIG. 1 illustrates an example of an audio apparatus which is arranged to generate an output audio signal from a first set of audio signals which represent captured audio of a scene from different positions.

The audio apparatus of FIG. 1 specifically comprises a receiver 101 which receives a first set of audio signals, and in the specific examples receives a set of microphone signals from a set of microphones capturing the audio scene from different positions. The microphones may for example be arranged in a linear array and relatively close to each other. For example, the maximum distance between capture points for the audio signals may in many embodiments not exceed 1 meter, 50 cm, 25 cm, or even in some cases 10 cm.

The input audio signals may be received from different sources, including internal or external sources. In the following an embodiment will be described where the receiver 101 is coupled to a plurality of microphones, such as a linear array of microphones, providing a set of input audio signals in the form of microphone signals.

The receiver 101 is coupled to an audio beamformer 103 arranged to generate a beamform output audio signal from the first set of audio signals. As will be described in more detail later, the audio beamformer 103 is arranged to generate the beamform output audio signal by performing a signal processing that includes spatial beamforming and spatial decorrelation of the first set of audio signals. Thus, both beamforming and decorrelation is implemented by the audio beamformer 103 to generate a beamform output audio signal that may specifically be directed to extract or isolate a desired audio source in the audio scene. As will be described in more detail later, the audio beamformer 103 is an adaptive beamformer in which both the decorrelation function and the beamforming function is adapted, and the audio beamformer 103 is specifically arranged to adapt its processing in response to the first set of input audio signals and the generated beamform output audio signal.

The audio beamformer 103 accordingly provides processing that achieves the effect of both a spatial decorrelation and an adaptive beamforming. The spatial decorrelation is controlled by a set of decorrelation parameters and the spatial beamforming is based on a set of beamform parameters. As will be described in more detail later, the decorrelation parameters may specifically be decorrelation coefficients for a set of spatial filters that are arranged to generate N output signals from N input signals where each output signal is generated as a weighted combination of samples from the N input signals. The decorrelation coefficients may specifically be the weights for such weighted combinations.

The beamform parameters may specifically be parameters describing or defining the combination of signals to generate the beamform output audio signal. The beamforming may include filtering a plurality of signals and combining the resulting filter output signals. The beamform parameters may specifically define the filters (and specifically be filter coefficients) and/or the combination (e.g. a weight of each signal). It will be appreciated that applying weights to signals may equivalently be considered to be part of the filtering and/or may be considered part of the combination operation. For example, if beamform output audio signal is generated by weighting (e.g. by a complex weight) and then summing the input signals, the weights can be considered a filtering and/or the combination can be considered to include the weighting (in which case the beamforming may not include any (other) filtering of the input signals). Specifically, weights for the input signals may be considered to be filter coefficients.
The audio beamformer 103 may adapt the spatial decorrelation by adapting the decorrelation parameters, and adapt the beamform operation by adapting the beamform parameters.

The audio beamformer 103 is coupled to an equalizer 105 which is arranged to apply a frequency equalization to the beamform output audio signal to generate an output signal of the audio apparatus. The equalizer may specifically apply a filtering to the beamform output audio signal with the filter having a given frequency response. The given frequency response is not fixed, constant, or predetermined but rather can be dynamically adapted during operation.

The audio apparatus comprises an equalization adapter 107 which is arranged to adapt the frequency equalization dependent on the set of beamform parameters used by the audio beamformer 103. The equalization adapter 107 is coupled to the audio beamformer 103 and receives the beamform parameters that are currently applied to determine the frequency response of the equalization. Thus, the equalization adapter 107 is arranged to adapt the frequency response of the equalizer 105 dependent on the beamform parameters (currently) applied by the audio beamformer 103.

In many embodiments, the adaptation of the frequency response of the equalizer 105 may also be dependent on the decorrelation parameters which are determined for the adaptive decorrelation by the audio beamformer 103. Thus, the equalization adapter 107 in many embodiments also receive the decorrelation parameters and proceed to evaluate these to determine/adapt the current frequency response.

The inventors have realized that the combination of spatial decorrelation and audio beamforming may provide improved performance and in particular may allow improved extraction of a desired audio source in the presence of a strong, and possibly dominant, noise source. The beamforming and decorrelation operations may synergistically interwork to suppress unwanted sources by decorrelating them for beamforming while still allowing coherence to remain for effective beamforming towards the desired source.

However, the inventors have also realized that whereas such an approach may provide efficient performance and advantageous operation in many scenarios, the combined effect may also impact the overall frequency response and introduce some frequency distortion. In particular, different frequency intervals may have different correlations and the combined impact of a decorrelator that seeks to remove correlation and a beamforming operation that seeks to exploit correlation by combining desired signal components may result in a non-flat frequency response. The inventors have further realized that the frequency impact is not constant or fixed but depends significantly on the operation performed by the audio beamformer 103.

The audio apparatus of FIG. 1 reflects these realizations and specifically the equalizer 105 may provide a frequency compensation by applying a frequency response that compensates for the frequency distortion of the audio beamformer 103. The frequency response of the equalizer 105 may be determined such that the combined frequency response of the audio beamformer 103 and the equalizer 105 is flatter than the frequency response of the audio beamformer 103. The equalization adapter 107 adapts the equalizer 105 so that the resulting compensating frequency response is dynamically changed to reflect the current operation of the audio beamformer 103. Specifically, the compensating frequency response (the frequency response of the equalizer 105) is adapted based on the beamforming parameters, and thus based on the parameters of the combining of signals as part of the combining. Advantageously, in many embodiments, the compensating frequency response may also be adapted based on the decorrelation parameters. Thus, in many embodiments, the compensating frequency response may be adapted to reflect both the current operation of the decorrelating function and the beamforming function.

Accordingly, the compensating frequency response is not determined from an evaluation of the signal components or the frequency content/distribution of the signal, or a frequency analysis or comparison of the signal components, but rather is controlled by the parameters determining the operation of the audio beamformer 103. These are typically changing much slower than signal properties, and a much lower complexity operation with substantially reduced computational resource can be implemented. Nevertheless, it has been found that the approach provides a highly efficient and high-performance operation from which an improved output signal can be generated. Specifically, the output signal may provide speech or other audio which sounds much more natural and closer to the actual sound in the audio scene. Often, frequency distortion can be reduced or even substantially removed from the output signal.

The equalization adapter 107 may in many embodiments be arranged to adapt the frequency equalization to have a low pass frequency response. In many embodiments, the equalization adapter 107 may be arranged to generate the compensating frequency response to have a magnitude that is monotonically decreasing for increasing frequency, at least in a frequency interval from 50Hz or 100Hz to 500Hz, 1kHz, 2kHz, or 4kHz. The equalization adapter 107 may generate the frequency response to provide a low frequency boost to the beamform output audio signal.

The inventors have realized that the decorrelation may have a frequency impact on the beamforming output as it may result in a frequency dependent decorrelation to wanted signals that the beamforming is being adapted to extract. For example, the decorrelation of a noise source may tend to also impact lower frequencies of a desired audio source as lower frequencies due to the longer wavelength tends to have higher correlation than at higher frequencies. Thus, for different audio sources and signals, the lower frequencies may tend to have similar correlation across the different microphones at different positions. Therefore, decorrelating one audio source (e.g. a noise or dominant source) will tend to also decorrelate other sources. This is more pronounced at lower frequencies than at higher frequencies.

Such decorrelation may tend to make the beamforming less efficient as it seeks to exploit correlation of a wanted signal component in the different captured signals, and thus may result in a reduced amplitude. As decorrelation of a wanted signal may be more pronounced at lower frequencies, the effect may result in a frequency dependent attenuation of the audio captured by the beamform output audio signal. The equalization adapter 107 may accordingly control the equalizer 105 to provide a bass boost (low pass characteristic) to compensate for this attenuation.

In many embodiments, the equalizer 105 may be arranged to determine the frequency equalization/the compensating frequency response to have/be a minimum phase frequency response. This may provide improved performance and perceived quality in many embodiments. It may reduce, and specifically minimize, the delay of the equalizer 105 and thus the overall delay of the capture operation and of the audio apparatus.

In many embodiments, the equalization adapter 107 may be arranged to first determine a magnitude compensating frequency response based on the beamform parameters (and optionally the decorrelation parameters) and may then proceed to determine the minimum phase filter for this magnitude response. Such an approach will be described in more detail later.

It will be appreciated that the specific operation performed by the audio beamformer 103, and the specific decorrelation and beamform combining, will be different in different embodiments. The impact of the beamforming operation on the overall frequency response will therefore depend on the specific details of the implementation, and accordingly the specific adaptation of the compensating frequency response and the dependence thereof on the beamform parameters will also vary and be implementation specific.

The combination of adaptive beamformer and spatial decorrelator functions has been found to provide very good results but at the cost of some (linear) frequency distortion. Due to the decorrelation, the frequency response of the desired audio/speech in the output of the beamformer is changed with respect to the situation without a decorrelation function. Typically, and depending on the position of both the desired audio source/speaker and point noise source as well as on the size of the microphone array, the decorrelation may result in an attenuation at low frequencies. At low frequencies, the wavelengths of the acoustic waves are large (e.g. more than 3 meters at 100 Hz) and the input covariance matrix for both a point noise source and a desired audio/speech source will not differ much for the low frequencies. The decorrelator function may decorrelate the noise signal, and as a result the noise signal will be attenuated, but as a side effect the desired audio/speech signal will also be (partly) attenuated at low frequencies. The signal to noise ratio is typically considerably increased, however, and for some applications, such as speech recognition and wake word detection, acceptable results are still obtained. However, for other applications, the frequency distortion may be highly undesirable. For example, for speech communication, the improvement in signal to noise ratio leads to good speech intelligibility, but the output of the beamformer will tend to sound less natural, due to the lack of low frequencies. The equalizer may be arranged to compensate for this by enhancing the low frequencies. Since the desired frequency characteristic of the equalizer cannot be known a priori, as it depends on the beamform and decorrelation parameters which vary with adaptation, an adaptive equalizer is employed.

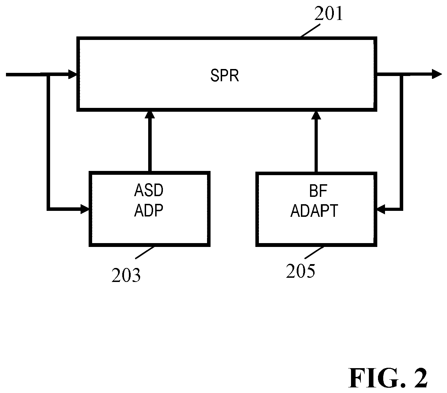

FIG. 2 illustrates an example of elements of the audio beamformer 103. The audio beamformer 103 includes a signal processor 201 which is arranged to generate the beamform output audio signal by a process that includes the effect of both spatial beamforming and spatial decorrelation being applied to the first set of audio signals.

In some embodiments, the spatial decorrelation may be a non-adaptive spatial decorrelation (e.g. with parameters manually set or set once at initialization (e.g. based on microphone distance measurements or on other measurements). However, in many embodiments, the spatial decorrelation is advantageously an adaptive spatial decorrelation and the following description will focus on embodiments employing an adaptive spatial decorrelation.

In order to adapt the adaptive spatial decorrelation, the audio beamformer 103 comprises a decorrelation adapter 203 which is arranged to adapt the parameters of the adaptive spatial decorrelation based on the input signals to the audio beamformer 103, i.e. based on the first set of audio signals. The audio beamformer 103 further comprises a beamform adapter 205 which is arranged to adapt the beamform parameters, and specifically the beamform/combination parameters determining the beamform filters may be adapted. The adaptation is based on the generated beamform output audio signal and in many embodiments the beamform parameters are adapted to maximize the signal level of the output signal. A number of different techniques for performing adaptive spatial decorrelation and beamforming are known and may be used without detracting from the invention.

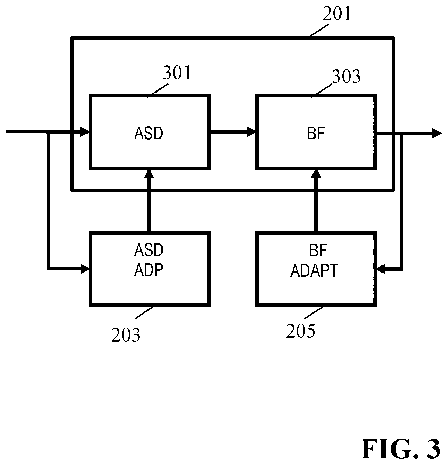

In many embodiments, the signal processor 201 is arranged to first perform the decorrelation on the first set of audio signals, i.e. on the input signals to the signal processor 201, to generate a decorrelated first set of audio signals and the beamform function is then applied to the decorrelated first set of audio signals to generate the beamform output audio signal. Such an approach is illustrated in FIG. 3 in which the signal processor 201 is shown to comprise a spatial decorrelator which in the specific example is an adaptive spatial decorrelator 301. The adaptive spatial decorrelator 301 receives the first set of audio signals and is arranged to generate the decorrelated first set of audio signals by performing the adaptive spatial decorrelation, such as specifically by filtering the first set of audio signals by a set of spatial decorrelation filters to result in the decorrelated first set of audio signals. The adaptive spatial decorrelator 301 may perform the decorrelating function based on the decorrelation parameters as determined by the decorrelation adapter 203, and specifically the decorrelation adapter 203 may determine filter parameters, such as filter coefficients, for the spatial decorrelation filters.

The decorrelated first set of audio signals is thus a set of audio signals for which the correlation/coherence (of at least one audio source) is reduced relative to the first set of audio signals.

The decorrelation adapter 203 may specifically comprise a set of spatial filters and may seek to adapt the spatial filters to be spatial decorrelation filters that seek to generate the output signals (the decorrelated first set of audio signals) to correspond to the input signals but with an increased decorrelation of the signals, specifically for one (dominant) audio source. The output audio signals are generated to have an increased spatial decorrelation with the cross correlation between audio signals being lower for the output audio signals than for the input audio signals. Specifically, the output signals may be generated to have the same combined energy/power as the combined energy/power of the input signals (or have a given scaling of this) but with an increased decorrelation (decreased correlation) between the signals. The output audio signals may be generated to include all the audio/signal components of the input signals in the output audio signals but with a re-distribution to different signals to achieve increased decorrelation.

The decorrelation filters may specifically be arranged to generate output signals that have a lower coherence/ normalized correlation than the input signals. The output signals of the decorrelation filters may thus have lower coherence/ normalized correlation than the coherence in the input signals to the decorrelation filters.

In some embodiments, the decorrelation adapter 203 may specifically be arranged to seek to decorrelate/decohere a noise/interference/undesired audio source from the captured signals. It may specifically be arranged to adapt the decorrelation when the noise/interference/undesired audio source is active. In many embodiments, it may be arranged to not adapt during times when a desired/wanted audio source is active. The beamform adapter may be arranged to adapt when the desired/wanted audio source is active but not when the noise/interference/undesired audio source is active. Thus, in many embodiments, the decorrelation adapter 203 may be arranged to adapt the decorrelation to the noise/interference/undesired audio source and the beamform adapter 205 may be arranged to adapt the beamforming to the desired/wanted audio source.

It will be appreciated that in different embodiments, different algorithms and functions may be used to decorrelate the input signals, and in particular different approaches for determining suitable filter coefficients for the decorrelation filters may be used.

In some embodiments, the decorrelation adapter 203 may for example comprise a neural network which based on the input samples is arranged to generate update values for modifying the filter coefficients of 301. The trained network may for example have been trained by training data that includes many different situations and associated update values that have manually been determined to modify weights towards increased decorrelation.

As another example, the decorrelation adapter 203 may comprise a location processor which, based on visual cues related to (changing) positions, is arranged to generate update values for modifying the filter coefficients.

As another example, the adapter 203 may determine the cross-correlation matrix of the input signals and compute its eigenvalue decomposition. The eigenvectors and eigenvalues can be used to construct a decorrelation.

As another example, the decorrelation adapter 203 may comprise a microphone distance processor, that is arranged to generate update values for modifying the filter coefficients for diffuse noise only situations. For diffuse noise the cross-correlation matrix of the input signals only depends on the distance between the microphones and can then be calculated. In the specific case of diffuse noise only, and with fixed distances between the microphones (static array), the calculation is only needed during initialization. Thus, in such cases, a static or non-adaptive spatial decorrelator 301 may be employed.

The second set of output signals are in the example of FIG. 3 fed to a beamform circuit 303 which is arranged to perform the spatial beamforming by combining the decorrelated first set of audio signals where the combining depends on the set of beamform parameters. The combining may specifically include a filtering of each of the decorrelated first set of audio signals with the filter outputs then being combined by e.g. a (weighted) summation.

It will be appreciated that many different beamformer algorithms are known and that any suitable approach or algorithm may be used by the audio beamformer 103.

For example, the beamformer adapter 205 may determine the cross-correlation matrix of its input signals and compute its eigenvalue decomposition and determine the eigenvectors that belong to the largest eigenvalue (principal component analysis). The eigenvectors can be used to construct the beamform parameters of the beamform circuit 303.

The beamform circuit 303 is arranged to receive a set of a plurality of audio signals from which a single signal is generated. The beamform circuit 303 seeks to combine the input signals such that the contributions from a given audio source are combined constructively. The beamform circuit 303 specifically combines the signals to perform a beamforming for the set of spatial audio signals capturing audio in an environment, such as for a set of signals from a microphone array. The beamform circuit 303 is arranged to generate a beamform output audio signal from the first set of audio signals.

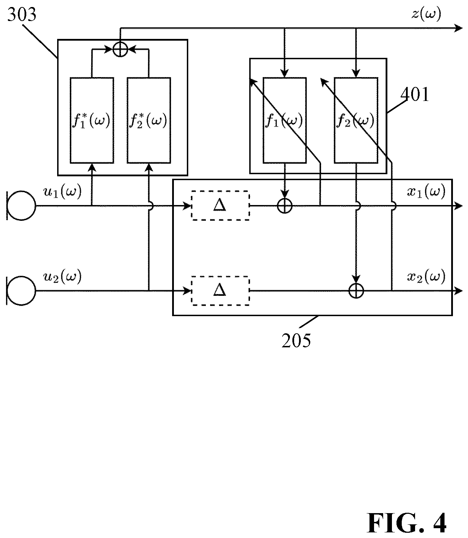

FIG. 4 illustrates an example of a possible beamform circuit 303 that may be particularly suitable and advantageous for the described audio apparatus.

The beamform circuit 303 of FIG. 4 specifically comprises a first set of filters ${f}_{1}^{∗} \left(ω\right)$, ${f}_{2}^{∗} \left(ω\right)$ which filters the first set of audio signals provided to the beamform circuit 303 (which as will be described later may specifically be the decorrelated first set of audio signals or may be the directly captured microphone signals). Each filter is arranged to filter one of the audio signals. Further, the filters are adaptive filters that are dynamically adapted to achieve an adaptive beamforming. The first set of filters will henceforth also be referred as beamformer filters.

The audio arrangement further comprises a feedback circuit 401 which comprises a second set of filters that generate a second set of audio signals from a filtering of the beamform output audio signal. The second set of filters will also be referred to as feedback filters. The input signals to the beamform circuit 303 may also be referred to as beamformer input signals and the signals generated by the feedback circuit may also be referred to as feedback signals. The feedback circuit 401 is used as part of the adaptation of the beamform operation and can be considered as part of the beamform adapter 205. However, for clarity it is in FIG. 4 (and the following figures) shown as separate to the beamform adapter 205.

The first and second set of filters are specifically matched/linked such that for each filter of the first set (i.e. for each beamformer filter) there is a filter of the second set (i.e. a feedback filter) which has a frequency response that is the complex conjugate of the corresponding beamformer filter. Thus, the filters of the beamform circuit 303 and the feedback circuit 401 are adapted together such that the filter coefficients provide a complex conjugate frequency response (equivalent/corresponding to time reversed filter impulse responses).

Thus, from the beamform output audio signal, the feedback circuit 401 generates a set of feedback signals with each feedback signal being generated from the beamform output audio signal by a time reversed/complex conjugate filtering by matching filters.

The beamform adapter 205 is arranged to adapt the first set of filters and the second set of filters, i.e. the beamformer filters and the feedback filters. The beamform adapter 205 is arranged to perform the adaptation based on a comparison of the first and the second set of audio signals, and specifically based on the comparison of the beamformer input signals and the feedback signals. Specifically, for each matching/linked beamformer input signal and feedback signal (signals for which the beamformer filter and the feedback filter have complex conjugate frequency responses), a difference measure may be determined, and the filters of the matching filters may be adapted to reduce/minimize the difference measure.

The arrangement of the beamform circuit 303, feedback circuit 401, and beamform adapter 205 may interact to provide a highly efficient adaptive beamforming which for a set of spatial audio signals may adapt the filters to form a beam towards an audio source with the beamform output audio signal providing the audio captured in the formed beam. The adaption of the filters to minimize the difference measures allows the beamformer arrangement to detect and track a given audio source. Specifically, in the ideal case, each of the beamformer filters concentrate all of the energy from a given audio source that is captured in one of the beamformer input signals into a single signal value. In the ideal case, this is achieved by the beamform filter having an impulse response that is the time inverse of the acoustic impulse response from the audio sources to the microphone capturing the signal. In the ideal case, this is achieved for all the signals/filters resulting in all the captured energy from the specific audio source being combined into a single value by a summation of the outputs of the beamformer filters thereby generating a sample value for the beamform output audio signal that maximizes the energy captured from the audio source.

Further, as each of the feedback filters are the complex conjugate frequency response of the corresponding beamformer filter, it is in the ideal case the same as the acoustic impulse response from the audio source to the microphone (signal). Accordingly, by filtering the beamform output audio signal by a feedback filter, a feedback signal is generated which reflects the signal that would be captured at the microphone from the audio source as represented by the beamform output audio signal. In the ideal case with only one audio source present and the filters being ideally adapted, the difference between the generated feedback signal and the captured microphone signal is zero. In the presence of other audio sources and/or noise, there may be a difference which is reflected in the difference measure. However, for uncorrelated noise/audio, the difference, and thus typically the difference measure, is typically zero on average and accordingly will tend to not prevent efficient adaptation. Thus, by adapting the filters for a given beamformer input signal to minimize the difference measure to the corresponding feedback signal, an adaptation towards the optimum beamforming filters can typically be achieved.

Such a beamforming approach is described in US 7 146 012. In the following, a more detailed description and analysis of the arrangement will be provided. This description will be based on the example of FIG. 4 where the adaptive beamformer arrangement consists of a filter part where the microphone signals are filtered by two filters ${f}_{1}^{∗} \left(ω\right)$ and ${f}_{2}^{∗} \left(ω\right)$ and the outputs are summed to obtain the output signal *z*(ω). In the update part the output signal *z*(ω) is fed to two adaptive filters *f*₁(ω) and *f*₂(ω) that have the respective microphone signals as a reference.

With this configuration we have an adaptive beamformer that maximizes the output power under the constraint: |*f*₁(ω)|² + |*f*₂(ω)|² = 1. The constraint is implied by the configuration, specifically because the conjugates of the filters *f*₁(ω) and *f*₂(ω) in the update part are copied to the filter part. The adaptive filters in the update part are "normal" unconstrained adaptive filters.

That the constraint is implied by the configuration can be seen if we look at the optimal solution, that is when both residual signals are zero. Suppose we have a speech signal *s*(ω) and transfer functions *h*₁(ω) and *h*₂(ω) from the speech source to the microphones. The microphone signals are then given by: *u*₁(ω) = *h*₁(ω)*s*(ω) and *u*₂(ω) = *h*₂(ω)*s*(ω).

The output signal z(w) then is: $\begin{matrix}z \left(ω\right) = {u}_{1} \left(ω\right) {f}_{1}^{∗} \left(ω\right) + {u}_{2} \left(ω\right) {f}_{2}^{∗} \left(ω\right) = \\ = s \left(ω\right) \left({h}_{1}\left(ω\right){f}_{1}^{∗}\left(ω\right)+{h}_{2}\left(ω\right){f}_{2}^{∗}\left(ω\right)\right) .\end{matrix}$ In the update part we get after convergence two equations, where we omit ω for convenience: $\left({h}_{1}{f}_{1}^{∗}+{h}_{2}{f}_{2}^{∗}\right) {f}_{1} = {h}_{1}$ (1) $\left({h}_{1}{f}_{1}^{∗}+{h}_{2}{f}_{2}^{∗}\right) {f}_{2} = {h}_{2}$ (2) From (1) and (2) follows (3): $\frac{{f}_{1}}{{f}_{2}} = \frac{{h}_{1}}{{h}_{2}}$ (3) Inserting (3) into (2) gives: $\left({h}_{1}\frac{{h}_{1}^{∗}}{{h}_{2}^{∗}}{f}_{2}^{∗}+{h}_{2}{f}_{2}^{∗}\right) {f}_{2} = {h}_{2}$ ${\left|{h}_{1}\right|}^{2} {\left|{f}_{2}\right|}^{2} + {\left|{h}_{2}\right|}^{2} {\left|{f}_{2}\right|}^{2} = {\left|{h}_{2}\right|}^{2}$ ${\left|{f}_{2}\right|}^{2} = \frac{{\left|{h}_{2}\right|}^{2}}{{\left|{h}_{1}\right|}^{2} + {\left|{h}_{2}\right|}^{2}}$ Similarly we get: ${\left|{f}_{1}\right|}^{2} = \frac{{\left|{h}_{1}\right|}^{2}}{{\left|{h}_{1}\right|}^{2} + {\left|{h}_{2}\right|}^{2}}$ fulfilling the constraint |*f*₁|² = |*f*₂|² = 1.

The solution for *f*₁ is given by: ${f}_{1} = \frac{{a}_{1} {h}_{1}}{\sqrt{{\left|{h}_{1}\right|}^{2} + {\left|{h}_{2}\right|}^{2}}}$ where *a*₁ is an allpass, i.e. |*a*₁| =1, phase undetermined.

Similarly for *f*₂: ${f}_{2} = \frac{{a}_{2} {h}_{2}}{\sqrt{{\left|{h}_{1}\right|}^{2} + {\left|{h}_{2}\right|}^{2}}}$

Since (3) still must hold, *a*₁ = *a*₂ = *a*, the so-called common all-pass term.

More generally, and using matrix notation, with $f \left(ω\right) = {\left[{f}_{1}\left(ω\right)…….{f}_{nmics}\left(ω\right)\right]}^{T}$ where ${f}_{m}^{∗} \left(ω\right)$ is the beamformer filter corresponding to the *m^{th}* microphone and $h \left(ω\right) = {\left[{h}_{1}\left(ω\right)…….{f}_{nmics}\left(ω\right)\right]}^{T}$ with *hₘ*(ω) the transfer function from the source *s*(*ω*) to the *m^{th}* microphone, we get for the output *z*(*ω*): $z \left(ω\right) = s \left(ω\right) {h}^{T} \left(ω\right) f * \left(ω\right)$ (4)

In the update part, after convergence we have the equality: $z \left(ω\right) f \left(ω\right) = s \left(ω\right) h \left(ω\right) ,$ (5) which leads to (since *z*(*ω*) and *s*(*ω*) are scalars): $f \left(ω\right) = α \left(ω\right) h \left(ω\right) ,$ (6) where *α*(*ω*) is a complex scaler.

Substituting (4) into (5), using (6) gives : $\left({h}^{T}\left(ω\right)h*\left(ω\right)\right) α * \left(ω\right) α \left(ω\right) h \left(ω\right) = h \left(ω\right)$ ${\left|α\left(ω\right)\right|}^{2} = \frac{1}{{h}^{T} \left(ω\right) h * \left(ω\right)}$ $α \left(ω\right) = \frac{a \left(ω\right)}{\sqrt{\left({h}^{T}\left(ω\right)h*\left(ω\right)\right)}}$ (7) with a(ω) the common allpass term.

Substituting (7) into (6) finally gives the solution after convergence (8): $f \left(ω\right) = a \left(ω\right) \frac{h \left(ω\right)}{\sqrt{{h}^{H} \left(ω\right) h \left(ω\right)}}$ (8) where (. )*^{H}* denotes complex conjugate transpose.

For the constraint we then get: ${f}^{H} \left(ω\right) f \left(ω\right) = 1$

To understand that the solution given by Eq. 8 is also the optimal solution that maximizes the output power, we look at the expected value of the update after convergence, which consists of a correlation between the residual signal (*x*₁(*ω*) and *x*₂(*ω*) in FIG. 4) and the conjugate of the input signal of the adaptive filters: $E \left\{z*\left(ω\right)\left(u\left(ω\right)-z\left(ω\right)f\left(ω\right)\right)\right\} = 0 ,$ with $u \left(ω\right) = {\left[{u}_{1}\left(ω\right)…….{u}_{nmics}\left(ω\right)\right]}^{T}$ where *uₘ*(ω) is the microphone signal of the *m^{th}* microphone.

This is equivalent to: $E \left\{z*\left(ω\right)u\left(ω\right)-{\left|z\left(ω\right)\right|}^{2}f\left(ω\right)\right\} = 0$ $\left.E\left\{z*\left(ω\right)u\left(ω\right)\right\}-E\left\{{\left|z\left(ω\right)\right|}^{2}\right\}f\left(ω\right)\right\} = 0$

Using *z*(ω) = ***u**^{T}*(ω)***f***^{*}(ω) and thus *z*^{*}(ω) = ***u**^{H}**f***(*ω*) we get: $E \left\{u\left(ω\right){u}^{H}\left(ω\right)\right\} f \left(ω\right) = E \left\{{\left|z\left(ω\right)\right|}^{2}\right\} f \left(ω\right)$ ${R}_{uu} \left(ω\right) f \left(ω\right) = {ρ}_{zz}^{2} \left(ω\right) f \left(ω\right)$ ${f}^{H} \left(ω\right) {R}_{uu} \left(ω\right) f \left(ω\right) = {ρ}_{z}^{2} \left(ω\right) {f}^{H} \left(ω\right) f \left(ω\right) = {ρ}_{z}^{2} \left(ω\right)$ with ***Rᵤᵤ***(ω) the input covariance matrix. From this we learn that ***f***(ω) and ${ρ}_{z}^{2} \left(ω\right)$ are an eigen vector and eigen value of the input covariance matrix respectively. It can be shown that a stable solution is obtained when ${ρ}_{z}^{2} \left(ω\right)$ is the largest eigen value. From matrix theory, we know that for a Hermitian matrix the maximum value of the Rayleigh coefficient (omitting ω): $\frac{{f}^{H} {R}_{uu} f}{{f}^{H} f}$ is obtained for the eigen vector that belongs to the largest eigen value. This proofs that the beamformer maximizes it output under the constraint ***f**^{H}**f** =* 1

When the microphone signals only contain the desired signal, such as specifically speech, with ***u***(ω) = *s*(ω)***h***(ω), then maximization of ***f**^{H}*(ω)***R**ᵤᵤ*(ω)***f***(ω) corresponds to the maximization of the desired signal/speech in the output.

If we consider the case with ***u***(ω) = *s*(ω)***h***(ω) *+ **v***(ω), where we assume that ***v***(ω) is uncorrelated noise with equal variance in all microphones i.e. $E \left\{{v}_{p}^{∗}\left(ω\right){v}_{q}\left(ω\right)\right\} = {ρ}_{vv}^{2} \left(ω\right) {δ}_{pq}$ ***R**ᵤᵤ*(ω) can be written as: ${R}_{uu} \left(ω\right) = {R}_{ss} \left(ω\right) + {ρ}_{vv}^{2} \left(ω\right) I \left(ω\right)$ Maximization of ***f**^{H}*(ω)***R**ᵤᵤ*(ω)***f***(ω) then corresponds to maximization of (using ***f**^{H}*(ω)***f***(ω) = 1): ${f}^{H} \left(ω\right) {R}_{uu} \left(ω\right) f \left(ω\right) = {f}^{H} \left(ω\right) {R}_{ss} \left(ω\right) f \left(ω\right) + {ρ}_{vv}^{2} \left(ω\right) ,$ which means that maximization corresponds to maximization of the speech and maximizing the Signal-to-Noise ratio.

Now assume that ***v***(ω) consists of correlated noise such that: ${R}_{uu} \left(ω\right) = {R}_{ss} \left(ω\right) + {R}_{nn} \left(ω\right)$ with ***R**ₙₙ*(ω) being the covariance matrix of the noise with off-diagonal elements that are non-zero.

Maximization of ***f**^{H}*(ω)***R**ᵤᵤ*(ω)***f***(ω) then leads to the maximization of: ${f}^{H} \left(ω\right) {R}_{uu} \left(ω\right) f \left(ω\right) = {f}^{H} \left(ω\right) {R}_{ss} \left(ω\right) f \left(ω\right) + {f}^{H} \left(ω\right) {R}_{nn} \left(ω\right) f \left(ω\right) ,$

This means that maximization of ***f**^{H}*(ω)***R**ᵤᵤ*(ω)***f***(ω) does not necessarily lead to a better Signal-to-Noise ratio since the choice of ***f*** not only determines the amount of speech in the output, but also the amount of noise in the output.

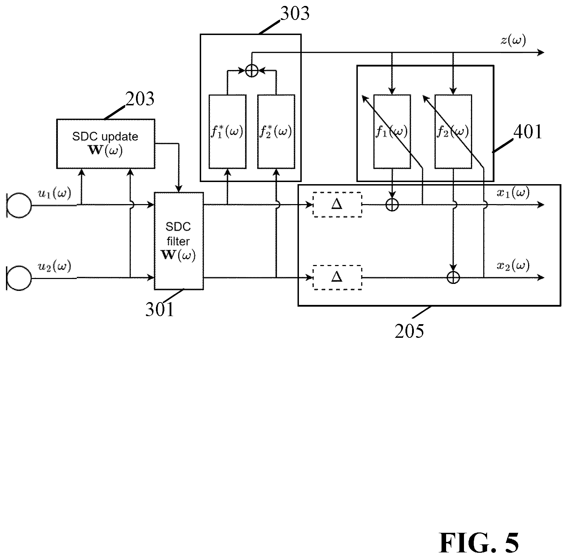

As described, improved performance may be achieved by including an adaptive spatial decorrelation function, e.g. specifically by including an adaptive spatial decorrelator 301 at the input to decorrelate the first set of audio signals. FIG. 5 illustrates such an example where the beamforming approach described with reference to FIG. 4 is further enhanced by introduction of an adaptive spatial filtering of the input signals.

The spatial filtering is performed across signals and is based on decorrelation coefficients/weights that are determined based on the input audio signals to adapt to the current audio properties. As will be described in more detail in the following, the spatial filtering may be placed at different places in the loop structure of the beamforming including as an inverse spatial decorrelation filtering in the feedback loop or as a spatial decorrelation filtering directly on the input signals being used by the beamforming. It has been found that the approach may provide substantially improved operation, such as e.g. substantially improved source separation, in many practical scenarios. In relation to the above analysis, the approach may in particular achieve that the noise contribution ***f**^{H}*(ω)***Rₙₙ***(ω)***f***(ω) may be made independent of the choice of ***f**.*

FIG. 5 illustrates an audio apparatus that may provide improved performance. In the example, the audio apparatus comprises the beamforming structure as described with reference to FIG. 4. However, the approach has further been enhanced by this structure operating on signals that have been spatially decorrelated by an adaptive spatial decorrelator 205.

The audio beamformer 103 of FIG. 2 receives a first set of audio signals and in the specific examples receives a set of microphone signals from a set of microphones capturing the audio scene from different positions. The microphones may for example be arranged in a linear array and relatively close to each other. For example, the maximum distance between capture points for the audio signals may in many embodiments not exceed 1 meter, 50 cm, 25 cm, or even in some cases 10 cm.

The input audio signals may be received from different sources, including internal or external sources. In the following an embodiment will be described where the audio beamformer 103 is coupled to a plurality of microphones, such as a linear array of microphones, providing a set of input audio signals in the form of microphone signals.

However, rather than the directly performing the operation of FIG. 4 on the microphone signals, the audio apparatus of FIG. 5 is arranged to apply an adaptive spatial decorrelation operation to the audio signals before the beamforming and adaptation operation. The spatial decorrelation is an adaptive decorrelation which is adapted based on the input audio signals so that the decorrelation may be continuously adapted to provide an increased decorrelation.

Specifically, the audio apparatus of FIG. 5 comprises an adaptive spatial decorrelator 301 in the form of a set of spatial (decorrelation) filters that apply a spatial filtering to the first set of audio signals. Thus, following the filtering by the spatial filters, the first set of audio signals are modified to have increased decorrelation/decoherence (for at least one audio source) than before the spatial decorrelation filtering.

The spatial filters are based on coefficients that are adapted by the decorrelation adapter 203 which in the example is a decorrelation adapter 203 that dynamically adapts and updates the filter coefficients used by the set of filters of the adaptive spatial decorrelator 301. The spatial filters are accordingly set to have coefficients that are determined by the decorrelation/coefficient adapter 203.

The beamforming, decorrelation, and adaptation may typically be performed in the frequency domain. The receiver 101 may comprise a segmenter which is arranged to segment the set of input audio signals into time segments. In many embodiments, the segmentation may typically be a fixed segmentation into time segments of a fixed and equal duration such as e.g. a division into time segments/intervals with a fixed duration of between 10-20msecs. In some embodiments, the segmentation may be adaptive for the segments to have a varying duration. For example, the input audio signals may have a varying sample rate and the segments may be determined to comprise a fixed number of samples. The segmentation may typically be into segments with a given fixed number of time domain samples of the input signals. For example, in many embodiments, the segmenter may be arranged to divide the input signals into consecutive segments of e.g., 256 or 512 samples.

The receiver 101 may be arranged to generate a frequency bin representation of the input audio signals and the first set of input signals further processed are typically represented in the frequency domain by a frequency bin representation. The audio apparatus may be arranged to perform frequency domain processing of the frequency domain representation of the input audio signals. The signal representation and processing are based on frequency bins and thus the signals are represented by values of frequency bins and these values are processed to generate frequency bin values of the output signals. In many embodiments, the frequency bins have the same size, and thus cover frequency intervals of the same size. However, in other embodiments, frequency bins may have different bandwidths, and for example a perceptually weighted bin frequency interval may be used.

In some embodiments, the input audio signals may already be provided in a frequency representation and no further processing or operation is required. In some cases, however, a rearrangement into suitable segment representations may be desired, including e.g. using interpolation between frequency values to align the frequency representation to the time segments.

In other embodiments, a filter bank, such as a Quadrature Mirror Filter, QMF, may be applied to the time domain input signals to generate the frequency bin representation. However, in many embodiments, a Discrete Fourier Transform (DFT) and specifically a Fast Fourier Transform, (FFT) may be applied to generate the frequency representation.

In the audio apparatus of FIG. 5, the spatial filters of the adaptive spatial decorrelator 301 specifically process the audio signals in the frequency domain. In the following description, the first set of audio signals may also be referred to as input audio signals (to the spatial filters) prior to the filtering and the resulting signals may also be referred as output audio signals (from the spatial filters).

For each frequency bin, an output frequency bin value is generated from one or more input frequency bin values of one or more input signals as will be described in more detail in the following. The output signals are generated to (typically/on average) reduce the correlation between signals relative to the correlation of the input signals, at least for one audio source which for example may be a dominant audio source.

The spatial filter set is arranged to filter the input audio signals. The filtering is a spatial filtering in that for a given output signal, the output value is determined from a plurality of, and typically all of the input audio signals (for the same time/segment and for the same frequency bin). The spatial filtering is specifically performed on a frequency bin basis such that a frequency bin value for a given frequency bin of an output signal is generated from the frequency bin values of the input signals for that frequency bin. The filtering/weighted combination is across the signals rather than being a typical time/frequency filtering.

Specifically, the frequency bin value for a given frequency bin is determined as the weighted combination of the frequency bin values of the input signals for that frequency bin. The combination may specifically be a summation and the frequency bin value may be determined as a weighted summation of the frequency bin values of the input signals for that frequency bin. The determination of a bin value for a given frequency bin may be determined as the vector multiplication of a vector of the weights/coefficients of the weighted summation and a vector comprising the bin values of the input signals: $\left[y\right] = \left[{w}_{1} {w}_{2} {w}_{3}\right] \left[\begin{matrix}{x}_{1} \\ {x}_{2} \\ {x}_{3}\end{matrix}\right]$ where y is the output bin value, w₁- w₃ are the weights of the weighted combination, and x₁- x₃ are the input signal bin values.

Representing the output bin values for a given frequency bin ω as a vector ***y***(ω), the determination of the output signals may be determined as: $y \left(ω\right) = W \left(ω\right) x \left(ω\right)$ where the matrix ***W***(ω) represents the weights/coefficients of the weighted summation for the different output signals and ***x***(ω) is a vector comprising the input signal values.
For example, for an example with only three input signals and output signals, the output bin values for the frequency bin ω may be given by $\left[\begin{matrix}{y}_{1} \\ {y}_{2} \\ {y}_{3}\end{matrix}\right] = \left[\begin{matrix}{w}_{11} & {w}_{12} & {w}_{13} \\ {w}_{21} & {w}_{22} & {w}_{23} \\ {w}_{31} & {w}_{32} & {w}_{33}\end{matrix}\right] \left[\begin{matrix}{x}_{1} \\ {x}_{2} \\ {x}_{3}\end{matrix}\right]$ where yₙ represents the output bin values, wᵢⱼ represents the weights of the weighted combinations, and xₘ represents the input signal bin values.

The decorrelation adapter 203 may seek to adapt the spatial filters to be spatial decorrelation filters that seek to generate the output signals to correspond to the input signals but with an increased decorrelation of the signals. The output audio signals are generated to have an increased spatial decorrelation with the cross correlation between audio signals being lower for the output audio signals than for the input audio signals. Specifically, the output signals may be generated to have the same combined energy/power as the combined energy/power of the input signals (or have a given scaling of this) but with an increased decorrelation (decreased correlation) between the signals. The output audio signals may be generated to include all the audio/signal components of the input signals in the output audio signals but with a re-distribution to different signals to achieve increased decorrelation.

The decorrelation filters may specifically be arranged to generate output signals that have a lower coherence/ normalized decorrelation than the input signals. The output signals of the decorrelation filters may thus have lower coherence normalized decorrelation than the coherence in the input signals to the decorrelation filters.

The decorrelation adapter 203 is arranged to determine update values for the weights of the weighted combination(s) forming the set of decorrelation filters. Thus, specifically, update values may be determined for the matrix ***W***(ω). The decorrelation adapter 203 may then update the weights of the weighted combination based on the update values.

The decorrelation adapter 203 is arranged to apply an adaptation approach that determines update values which may allow the output signals of the set of decorrelation filters 301 to represent the audio of the input signals to the set of decorrelation filters 301 but with the output signals typically being more decorrelated than the input signals.

The decorrelation adapter 203 is arranged to use a specific approach of adapting the weights based on the generated output signals. The operation is based on each output audio signal being linked with one input audio signal. The exact linking between output signals and input signals is not essential and many different (including in principle random) linkings/pairings of each output signal to an input signal may be used. However, the processing is different for a weight that reflects a contribution from an input signal that is linked to/paired with the output signal for the weight than the processing for a weight that reflects a contribution from an input signal that is not linked to/paired with the output signal for the weight. For example, in some embodiments, the weights for linked signals (i.e. for input signals that are linked to the output signal generated by the weighted combination that includes the weight) may be set to a fixed value and not updated, and/or the weights for linked signals may be restricted to be real valued weights whereas other weights are generally complex values.

The decorrelation adapter 203 uses an adaptation/update approach where an update value is determined for a given weight that represents the contribution to a bin value for a given output signal from a given non-linked input signal based on a correlation measure between the output bin value for the given output signal and the output bin value for the output signal that is linked with the given (non-linked) input signal. The update value may then be applied to modify the given weight in the subsequent segment, or the update value for weight in a given segment is determined in response to two output bin values of a (and typically the immediate) prior segment, where the two output values represent respectively the input signal and the output signal to which the weight relate.

The described approach is typically applied to a plurality, and typically all, of the weights used in determining the output bin values based on a non-linked input signal. For weights relating to the input signal that is linked to the output signal for the weight, other considerations may be used, such as e.g. setting the weight to a fixed value as will be described in more detail later.

Specifically, the update value may be determined in dependence on a product of the output bin value for the weight and the complex conjugate of the output bin value linked to the input signal for the weight, or equivalently in dependence on a product of the complex conjugate of the output bin value for the weight and the output bin value linked to the input signal for the weight. As a specific example, an update value for segment k+1 for frequency bin ω may be determined in dependence on the correlation measure given by: $\left[{y}_{i}\left(k, ω\right){y}_{j}^{∗}\left(k, ω\right)\right]$ or equivalently by: $\left[{y}_{i}^{∗}\left(k, ω\right){y}_{j}\left(k, ω\right)\right]$ where *yᵢ*(*k*, ω) is the output bin value for the output signal i being determined based on the weight; and *yⱼ*(*k*, ω) is the output bin value for the output signal j that is linked to the input signal from which the contribution is determined (i.e. the input signal bin value that is multiplied by the weight to determine a contribution to the output bin value for signal i).

The measure of $\left[{y}_{i}\left(k, ω\right){y}_{j}^{∗}\left(k, ω\right)\right]$ (or the conjugate value) indicates the correlation of the time domain signal in the given segment. In the specific example, this value may then be used to update and adapt the weight w_{i,j}(k+1,ω).

As previously mentioned, the set of decorrelation filters may be arranged to determine the output bin values for the output signals for the given frequency bin ω from: $y \left(ω\right) = W \left(ω\right) x \left(ω\right)$ where **y**(ω) is a vector comprising the frequency bin values for the output signals for the given frequency bin ω; **x**(ω) is a vector comprising the frequency bin values for the input audio signals for the given frequency bin ω; and **W**(ω) is a matrix having rows comprising weights of a weighted combination for the output audio signals.

In the example, the decorrelation adapter 203 may specifically be arranged to adapt at least some of the weights *wᵢⱼ* of the matrix **W**(ω) according to: ${w}_{ij} \left(k+1,ω\right) = {w}_{ij} \left(k, ω\right) - η \left(k, ω\right) \left[{y}_{i}\left(k, ω\right) {y}_{j}^{*}\left(k, ω\right)\right]$ where i is a row index of the matrix **W**(ω) , j is a column index of the matrix **W**(ω) , k is a time segment index, ω represents the frequency bin, and *η*(*k,* ω ) is a scaling parameter for adapting an adaptation speed. Typically, the decorrelation adapter 203 may be arranged to adapt all the weights that are not relating the input signal with the linked output signal (i.e. "cross-signal" weights).

In some embodiments, the decorrelation adapter 203 may be arranged to adapt the update rate/speed of the adaptation of the weights. For example, in some embodiments, the adapter may be arranged to compensate the correlation measure for a given weight in dependence on the signal level of the output bin value to which a contribution is determined by the weight.

As a specific example, the compensation value $\left[{y}_{i}\left(k, ω\right){y}_{j}^{∗}\left(k, ω\right)\right]$ may be compensated by the signal level of the output bin value, |*yᵢ*(*k,* ω)|. The compensation may for example be included to normalize the update step values to be less dependent on the signal level of the generated decorrelated signals.

In many embodiments, such a compensation or normalization may specifically be performed on a frequency bin basis, i.e. the compensation may be different in different frequency bins. This may in many scenarios improve the operation and may typically result in an improved adaptation of the weights generating the decorrelated signals.

The compensation may for example be built into the scaling parameter *η*(*k*, ω ) of the previous update equation. Thus, in many embodiments, the decorrelation adapter 203 may be arranged to adapt/change the scaling parameter *η*(*k*, ω ) differently in different frequency bins.

In many embodiments, the arrangement of the input signal vector **x**(ω) the output signal vector **y**(ω) is such that linked signals are at the same position in the respective vectors, i.e. specifically *y*₁ is linked with *x*₁, *y*₂ with *x*₂, *y*₃ is with *x*₃, etc. In this case, the weights for the linked signals are on the diagonal of the weight matrix **W**(*k*, ω). The diagonal values may in many embodiments be set to a fixed real value, such as e.g. specifically be set to a constant value of 1.

In many embodiments, the weights/spatial filters/weighted combinations may be such that the weights for a contribution to a first output signal from a first input signal (not linked to the first output signal) is a complex conjugate of the contribution to a second output signal being linked with the first input signal from a second input signal being linked with the first input signal. Thus, the two weights for two pairs of linked input/output signals are complex conjugates.

In the example of the weights for linked input and output signals being arranged on the diagonal of the weight matrix **W**(ω), this results in a Hermitian matrix. Indeed, in many embodiments, the weight matrix **W**(ω) is a Hermitian matrix. Specifically, the coefficients/weights of the weight matrix **W**(ω) may meet the criterion: ${w}_{ij} = {w}_{ji}^{∗} .$

As previously mentioned, the weights for the contributions to an output signal bin value from the linked input signal (corresponding to the values of the diagonal of the weight matrix **W**(ω) in the specific example) are treated differently than the weights for non-linked input signals. The weights for linked input signals will in the following for brevity also be referred to as linked weights and the weights for non-linked input signals will in the following for brevity also be referred to as non-linked weights, and thus in the specific example the weight matrix **W**(ω) will be a Hermitian matrix comprising the linked weights on the diagonal and the non-linked weights outside the diagonal.

In many approaches, the adaptation of the non-linked weights is such that it seeks to reduce the correlation measures. Specifically, each update value may be determined to reduce the correlation measure. Overall, the adaptation will accordingly seek to reduce the cross-correlations between the output signals. However, the linked weights are determined differently to ensure that the output signals maintain a suitable audio energy/power/level. Indeed, if the linked weights where instead adapted to seek to reduce the autocorrelation of the output signal for the weight, there is a high risk that the adaptation would converge on a solution where all weights, and thus output signals, are essentially zero (as indeed this would result in the lowest correlations). Further, the audio apparatus is arranged to seek to generate signals with less cross-correlation but do not seek to reduce autocorrelation.

Thus, in many embodiments, the linked weights may be set to ensure that the output signals are generated to have a desirable (combined) energy/power/level.

In some cases, the decorrelation adapter 203 may be arranged to adapt the linked weights, and in other cases the adapter may be arranged to not adapt the linked weights.

For example, in some embodiments, the linked weights may simply be set to a fixed constant value that is not adapted. For example, in many embodiments, the linked weights may be set to a constant scalar value, such as specifically to the value 1 (i.e. a unitary gain being applied for a linked input signal). For example, the weights on the diagonal of the weight matrix **W**(ω) may be set to 1.

Thus, in many embodiments, the weight for a contribution to a given output signal frequency bin value from a linked input signal frequency bin value may be set to a predetermined value. This value may in many embodiments be maintained constant without any adaptation.

Such an approach has been found to provide very efficient performance and may result in an overall adaptation that has been found to provide output signals to be generated that provide a highly accurate representation of the original audio of the input signals but in a set of output signals that have increased decorrelation.

In some embodiments, the linked weights may also be adapted but will be adapted differently than the non-linked weights. In particular, in many embodiments, the linked weights may be adapted based on the output signals.

Specifically, in many embodiments, a linked weight for a first input signal and linked output signal may be adapted based on the generated output bin value of the linked audio signal, and specifically based on the magnitude of the output bin value.

Such an approach may for example allow a normalization and/or setting of the desired energy level for the signals.

In many embodiments, the linked weights are constrained to be real valued weights whereas the non-linked weights are generally complex values. In particular, in many embodiments, the weight matrix **W**(ω) may be a Hermitian matrix with real values on the diagonal and with complex values outside of the diagonal.

Such an approach may provide a particular advantageous operation and adaptation in many scenarios and embodiments. It has been found to provide a highly efficient spatial decorrelation while maintaining a relatively low complexity and computational resource.

The adaptation may gradually adapt the weights to increase the decorrelation between signals. In many embodiments, the adaptation may be arranged to converge towards a suitable weight matrix **W**(ω) regardless of the initial values and indeed in some cases the adaptation may be initialized by random values for the weights.

However, in many embodiments, the adaptation may be started with advantageous initial values that may e.g. result in faster adaptation and/or result in the adaptation being more likely to converge towards more optimal weights for decorrelating signals.

In particular, in many embodiments, the weight matrix **W**(ω) may be arranged with a number of weights being zero but at least some weights being non-zero. In many embodiments, the number of weights being substantially zero may be no less than 2,3,5, or 10 times the number of weights that are set to a non-zero value. This has been found to tend to provide improved adaptation in many scenarios.

In particular, in many embodiments, the decorrelation adapter 203 may be arranged to initialize the weights with linked weights being set to a non-zero value, such as typically a predetermined non-zero real value, whereas non-linked weights are set to substantially zero. Thus, in the above example where linked signals are arranged at the same positions in the vectors, this will result in an initial weight matrix **W**(ω) having non-zero values on the diagonal and (substantially) zero values outside of the diagonal.

Such initializations may provide particularly advantageous performance in many embodiments and scenarios. It may reflect that due to the audio signals typically representing audio at different positions, there is a tendency for the input signals to be somewhat decorrelated. Accordingly, a starting point that assumes the input signals are fully correlated is often advantageous and will lead to a faster and often improved adaptation.

It will be appreciated that the weights, and specifically the non-linked weights, may not necessarily be exactly zero but may in some embodiments be set to low values close to zero. However, the initial non-zero values may be at least 5,10,20 or 100 times higher than the initially substantially zero values.

The described approach may provide a highly efficient adaptive spatial decorrelator that may generate output signals that represent the same audio as the input signals but with increased decorrelation. The approach has in practice been found to provide a highly efficient adaptation in a wide variety of scenarios and in many different acoustic environments and for many different audio sources. For example, it has been found to provide a highly efficient decorrelation of speaker signals in environments with multiple speakers.

The adaptation approach is furthermore computationally efficient and in particular allows localized and individual adaptation of individual weights based only on two signals (and specifically on only two frequency bin values) closely related to the weight, yet the process results in an efficient and often substantially optimized global optimization of the spatial filtering, and specifically the weight matrix **W**(ω). The local adaptation has been found to lead to a highly advantageous global adaptation in many embodiments.

A particular advantage of the approach is that it may be used to decorrelate convolutive mixtures and is not limited to only decorrelate instantaneous mixtures. For a convolutive mixture, the full impulse response determines how the signals from the different audio sources combine at the microphones (i.e. the delay/timing characteristics are significant) whereas for instantaneous mixes a scalar representation is sufficient to determine how the audio sources combine at the microphones (i.e. the delay/timing characteristics are not significant). By transforming a convolutive mixture into the frequency domain, the mixture can be considered a complex-valued instantaneous mixture per frequency bin.

The decorrelation adapter 203 thus determines the coefficients for the set of spatial decorrelation filters of the adaptive spatial decorrelator 301 such that these modify the first set of audio signals to represent the same audio but with an increased decorrelation/decoherence for at least one of the audio sources. Such a decorrelation of the audio signals to which the previously described beamforming approach is then applied may substantially improve the overall performance in many scenarios. Indeed, it may in many scenarios result in improved separation and selection of a specific audio source, such as a specific speaker. Thus, counterintuitively, the decorrelation of signals may provide improved beamforming performance despite the beamforming inherently being based on exploiting and adapting to correlation between audio signals from different positions to extract/separate an audio source by spatially forming a beam towards the desired source. Indeed, the decorrelation inherently breaks the link between the audio signals and the specific location in the audio scene that is typically exploited by a beamforming operation. However, the Inventors have realized that despite this, the decorrelation may provide highly advantageous effects and improved performance in many scenarios. For example, in the presence of a strong noise source, the approach may facilitate and/or improve the extraction/isolation of a specific desired audio source such as specifically a speaker.

The specific adaptation described above may provide a highly advantageous approach in many embodiments. It may typically provide a low complexity yet highly accurate adaptation to result in spatial decorrelation filters that generate highly decorrelated signals. In particular, it may allow local adaptation of individual weights/filter coefficients to result in a highly efficient global decorrelation of the first set of audio signals.

However, it will be appreciated that in other embodiments, other approaches for adapting the spatial filters/decorrelation filters may be used.

In the following, the output z(w) of the audio beamformer 103 of FIG. 5 will be derived. In this example, which will also in the following be referred to as configuration A, the set of spatial filters is placed directly after the microphones, completely outside the beamformer. This has the advantage that nothing has to be changed to the beamformer algorithm: it will still have the constraint ***f**^{H}*(ω)***f***(ω) = 1 only the inputs differ.

A suitable decorrelator may be as previously described. This decorrelator transforms the noise covariance matrix ***R**ₙₙ*(ω) into: $W \left(ω\right) {R}_{nn} \left(ω\right) {W}^{H} \left(ω\right) = Λ \left(ω\right)$ (9) where **Λ**(ω) = *diag*(***λ*₁**(ω) *... . . **λ**_{**N**mics}* (ω)) is a diagonal matrix and W(w) the *nmics x nmics* decorrelation matrix of the adaptive spatial decorrelator 301. Instead of maximizing ***f**^{H}*(*ω*)***R**ᵤᵤ*(ω)***f***(ω) the beamformer now maximizes ***f^{H}***(ω)***W***(ω)***R**ᵤᵤ*(ω)***W^{H}***(ω)***f***(ω) which can be written as $\begin{matrix}{f}^{H} \left(ω\right) W \left(ω\right) {R}_{ss} \left(ω\right) {W}^{H} \left(ω\right) f \left(ω\right) + {f}^{H} \left(ω\right) W \left(ω\right) {R}_{nn} \left(ω\right) {W}^{H} \left(ω\right) f \left(ω\right) \\ = {f}^{H} \left(ω\right) W \left(ω\right) {R}_{ss} \left(ω\right) {W}^{H} f \left(ω\right) + {f}^{H} \left(ω\right) Λ \left(ω\right) f \left(ω\right)\end{matrix}$

If A(w) is a scaled version of the identity matrix and can be written as β(ω)***I***, ***f^{H}***(ω)**Λ**(*ω*)***f***(ω) transforms to β(ω) and the noise contribution is independent of the choice of ***f***(ω) and maximization of ***f^{H}***(ω)***W***(ω)***R**ᵤᵤ*(ω)***W^{H}***(ω)***f***(ω) leads to maximization of the Signal-to-Noise ratio in the output.

The choice of β(ω) in the adaptive spatial decorrelator 301 does not influence the SNR but influences the level of the speech in the output. Suppose we choose β(ω) = 1 and the noise level at the input increases by a factor of 2, then all the coefficients in ***W***(ω) will be scaled by a factor of 0.5, so also decreasing the level of the speech at the output of the adaptive spatial decorrelator 301. The adaptive spatial decorrelator 301 keeps updating depending on the level of the input (per frequency bin). As a result, also the beamformer keeps updating. It can be shown that $Λ \left(ω\right) = α \left(ω\right) {ρ}_{nn}^{2} \left(ω\right) I$, i.e. linearly related to the power of the noise source, ***W***(ω) only depends on the acoustic transfer functions between the noise source and the microphones. Since the transfer functions generally vary much more slowly when compared to the noise characteristics, this is also advantageous for the beamformer, since it sees a "stable" path. A solution is specifically where diag(***W***(ω)) = ***I***. **Λ**(ω) will have elements ***λᵢ***(ω) that are linearly related to the input. A disadvantage is that not all elements of **Λ**(ω) are equal and as a result, the noise in the output depends on ***f***(ω). Although this is not desirable, in practice it was found that it is typically more important that ***W***(ω)***R**ₙₙ*(ω)***W^{H}***(ω) does not contain off-diagonal elements then that all the elements on the diagonal are equal. The combined solution with a beamformer preceded by a decorrelator with *diag*(***W***(ω)) = ***I*** has proven to be very effective.

The optimal coefficients for the beamformer can be found, using Equation (8) with instead of ***h***(ω) using the output of the spatial decorrelator: ***W***(ω)***h***(ω).

Using a decorrelator with ***W***(ω) Hermitian and thus ***W**^{H}*(ω) = ***W***(ω) we get for the optimal solution: $\begin{matrix}{f}_{opt} \left(ω\right) = a \left(ω\right) \frac{W \left(ω\right) h \left(ω\right)}{\sqrt{{h}^{H} \left(ω\right) W \left(ω\right) W \left(ω\right) h \left(ω\right)} ,} \\ = a \left(ω\right) \frac{W \left(ω\right) h \left(ω\right)}{\sqrt{{h}^{H} \left(ω\right) {W}^{2} \left(ω\right) h \left(ω\right)}}\end{matrix}$

The output of the combination is given by: $z \left(ω\right) = {f}_{opt}^{H} \left(ω\right) W \left(ω\right) x \left(ω\right)$ (Eq. 10) $u \left(ω\right) = s \left(ω\right) h \left(ω\right)$ (Eq. 11) ${f}_{opt}^{H} \left(ω\right) = \frac{{a}^{∗} \left(ω\right) {h}^{H} \left(ω\right) W \left(ω\right)}{\sqrt{{h}^{H} \left(ω\right) {W}^{2} \left(ω\right) h \left(ω\right)}}$ (Eq. 12)

Substituting (12) and (11) into (10) gives for the output: $\begin{matrix}z \left(ω\right) = a * \left(ω\right) \frac{{h}^{H} \left(ω\right) W \left(ω\right) W \left(ω\right) h \left(ω\right)}{\sqrt{{h}^{H} \left(ω\right) {W}^{2} \left(ω\right) h \left(ω\right)}} s \left(ω\right) \\ = a * \left(ω\right) \sqrt{{h}^{H} \left(ω\right) {W}^{2} \left(ω\right) h \left(ω\right)} s \left(ω\right)\end{matrix}$

Note that with equal variance uncorrelated noise at the inputs, using the decorrelator with *diag*(*W*(ω)) = ***I*** and thus ***W***²(ω) = **W**(ω) = **I,** we get the same solution as without decorrelator and with only the beamformer.

The determination of the beamform output audio signal z(ω) can be used to determine the optimal compensating frequency response of the equalizer 105 for a given desired frequency response. Specifically, for the beamform output audio signal z(w) given as: $z \left(ω\right) = a * \left(ω\right) \sqrt{{h}^{H} \left(ω\right) {W}^{2} \left(ω\right) h \left(ω\right)} s \left(ω\right)$ it can be derived that when only equivariant uncorrelated noise is present in the first set of audio signals/the microphone signals, the output can be written as: $z \left(ω\right) = a * \left(ω\right) \sqrt{{h}^{H} \left(ω\right) h \left(ω\right)} s \left(ω\right)$ (since decorrelation has no effect on equivariant uncorrelated noise).

In the case where correlated noise is present, it is desired to have the same frequency characteristic for the speech as in the case where no noise or equivariant uncorrelated noise is present. This means that we would like to have a compensating frequency response magnitude response |*h_{eq}*(ω)| of: $\left|{h}_{eq}\left(ω\right)\right| = \sqrt{\frac{{h}^{H} \left(ω\right) h \left(ω\right)}{{h}^{H} \left(ω\right) {W}^{2} \left(ω\right) h \left(ω\right)}}$ ***h***(ω) is not known, but as previously shown the optimal filter frequency responses ***f**ₒₚₜ*(ω) only depend on ***h***(ω) and ***W***(ω), and it is accordingly possible to write |*h_{eq}*(ω)| as a function of *fₒₚₜ*(ω) and ***W***(ω). Specifically, we get the optimal magnitude response: $\left|{h}_{eq}\left(ω\right)\right| = \sqrt{{f}_{opt}^{H} \left(ω\right) {W}^{- 2} \left(ω\right) {f}_{opt} \left(ω\right)}$

Thus, ***f***ₒₚₜ(ω) = [*f*_{1,*opt*}(ω) ... ... . *f_{nmics,opt}*(ω)]*^{T}* (where index opt indicates the optimal adapted values) represents the adapted frequency responses of the beamform filters and accordingly are given by the beamform parameters. Furthermore, ***W***(ω) and thus ***W***⁻²(ω), represent the decorrelation coefficients and thus are given by the decorrelation parameters. Therefore, based on the current decorrelation parameters and the beamform parameters, the equalization adapter 107 may proceed to determine the magnitude compensating frequency response given above and control the equalizer 105 to apply this compensating frequency response to the beamform output audio signal.

Specifically, substituting ${f}_{opt} \left(ω\right) = \frac{a \left(ω\right) W \left(ω\right) h \left(ω\right)}{\sqrt{{h}^{H} \left(ω\right) {W}^{2} \left(ω\right) h \left(ω\right)}}$ into the equation for |*h_{eq}*(ω)| yields: $\begin{matrix}\left|{h}_{eq}\left(ω\right)\right| = \sqrt{\frac{a * \left(ω\right) {h}^{H} \left(ω\right) W \left(ω\right) {W}^{- 1} \left(ω\right) {W}^{- 1} \left(ω\right) a \left(ω\right) W \left(ω\right) h \left(ω\right)}{{h}^{H} \left(ω\right) {W}^{2} \left(ω\right) h \left(ω\right)}} \\ = \sqrt{\frac{{h}^{H} \left(ω\right) h \left(ω\right)}{{h}^{H} \left(ω\right) {W}^{2} \left(ω\right) h \left(ω\right)}}\end{matrix}$

Thereby showing that this approach results in the desired compensating frequency response as given above.

The phase characteristic may be determined to provide suitable performance, and in many embodiments it may be determined to be a minimum phase characteristic in order to minimize the delay. Different algorithms and approaches for creating a minimum-phase characteristic from a given amplitude spectrum are known and will for brevity not be described further herein. (Ref, e.g. A.V. Oppenheim and R.W. Shafer, "Digital Signal Processing", Englewood Cliffs (New York, USA): Prentice-Hall, 1975 or A.V. Oppenheim and R.W. Shafer, "Discrete-time Signal Processing", Englewood Cliffs (New York, USA): Prentice-Hall, 1989).

In the previous examples, the spatial decorrelation function and the beamforming function are implemented by an adaptive spatial decorrelator 301 that applies decorrelation to the first set of audio signals and a beamform circuit 303 which then operates on the resulting output signals of the adaptive spatial decorrelator 301. However, the same overall function can be achieved in other ways including performing decorrelation or inverse decorrelation at a different part of the beamformer feedback or adaptation circuit.

In the example of FIG. 5, the decorrelation and spatial decorrelation filters are directly applied to the first set of audio signals before these are fed to both the beamform circuit 303 and the beamform adapter 205. However, other approaches of adapting the operation based on applying a spatial/cross signal filtering using coefficients that are derived from the determined decorrelation coefficients may be used.

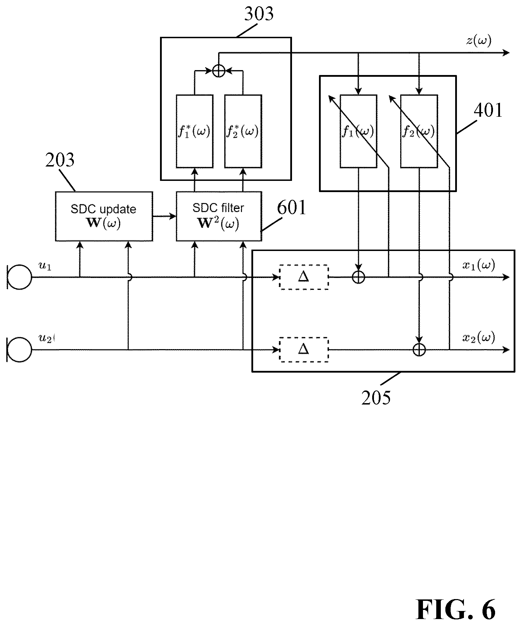

Specifically, FIG. 6 illustrates an example, which will also be referred to as configuration B, where the audio beamformer 103 is arranged to perform a spatial filtering of the first set of audio signals before these are filtered by the first set of filters, i.e. the beamforming is based on the first set of audio signals after these have been filtered by a set of spatial filters 601. However, in the example, the beamform adapter 205 receives the first set of audio signals before any filtering by the set of filters 601, i.e. the second set of filters are applied only to the beamformer path and not to the adaptation path. The coefficients for this set of spatial filters 601 are determined from the decorrelation coefficients that have been determined by the decorrelation adapter 203. Indeed, in some embodiments, the approach described with reference to the configuration of FIG. 5 may be applied directly and the resulting second set of filters may be applied (only) to the signals of the beamform path.

However, in many embodiments, the set of spatial filters 301 in the configuration example of FIG. 5 will be different from the set of spatial filters 601 in the configuration example of FIG. 6. In particular, in many embodiments, the set of spatial filters will be modified to correspond to a cascade of two sets of decorrelation filters as determined by the decorrelation adapter 203. Thus, filter coefficients of the set of spatial filters 601 have coefficients matching coefficients of a spatial filter that is a cascade of two of the set of decorrelation filters. This can typically be considered equivalent to a double/repeated filtering of the first set of audio signals by the set of decorrelation filters determined by the decorrelation adapter 203.

In particular, the decorrelation adapter 203 may determine the weights/coefficients of a weight matrix **W**(ω) for a decorrelation filter that can decorrelate the first set of audio signals in accordance with: $y \left(ω\right) = W \left(ω\right) x \left(ω\right)$ as previously described.

The set of spatial filters 601 may in this case be generated to correspond to a cascaded application of two such filters, i.e. it may be arranged to correspond to: $y \left(ω\right) = W \left(ω\right) W \left(ω\right) x \left(ω\right) = {W}^{2} \left(ω\right) x \left(ω\right)$

Thus, in the example, the decorrelation adapter 203 may proceed to perform the adaptation as described for the example of FIG. 5 to determine suitable coefficients for a set of spatial decorrelation filters that would decorrelate the first set of audio signals. In some cases, such filters may then be applied by the set of spatial filters 601 in FIG. 6. However, in many embodiments, the determined decorrelation filters are not used directly but rather coefficients for the set of spatial filters 601 are determined from the determined coefficients for the decorrelation filters. In such cases, the decorrelation adapter 203 may as part of the determination/adaptation of coefficients implement a decorrelation filter and apply this to the first set of signals (e.g. in order to determine update values from $\left[{y}_{i}\left(k, ω\right){y}_{j}^{∗}\left(k, ω\right)\right]$. However, in the specific example, such filtered signals may only be used for the adaptation process and may not be used further in the beamforming/ processing. Instead, the set of spatial filters 601 that are applied may be generated from the decorrelation coefficients/weight matrix ***W***(ω), specifically as **W**²(ω).

The approach may provide improved overall performance including an improved beamforming experience. Indeed, it can be shown that for the example where the set of spatial filters 601 of FIG. 6 are set to coefficients corresponding to **W²** then this may result in the same performance, results, and output signal as for the example of FIG. 5 It can be shown that these approaches may result in the same optimum solutions.

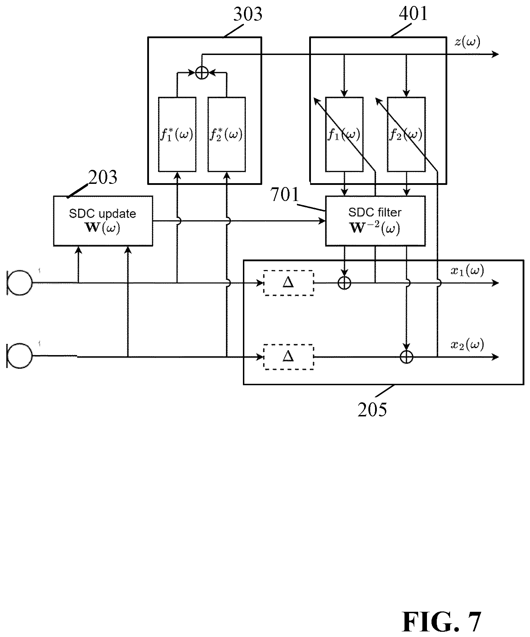

Another possible example of applying a spatial filtering by a set of spatial filters determined from the decorrelation coefficients determined by the decorrelation adapter 203 is illustrated in FIG. 7, which will also be referred to as configuration C. In this example, the first set of audio signals is not filtered by the set of spatial filters but rather the second set of audio signals generated by the feedback circuit 401 are filtered by the set of spatial filters 701. Thus, in this example, the feedback signals rather than the input to the audio beamformer 103 are filtered by the set of spatial filters.

Further, the set of spatial filters may be determined as a set of a set of inverse spatial decorrelation filters where each of the inverse spatial decorrelation filters may include an inverse filtering of a determined decorrelation filter.

For example, if the spatial decorrelation filter is represented by the weight matrix ***W***(ω), an inverse spatial decorrelation filter may be determined by the weight matrix **W⁻¹**(ω). Thus, in many embodiments, the set of spatial filters applied to the second set of audio signals may include a filtering corresponding to **W⁻¹**(ω) where **W**(ω) is the spatial decorrelation determined by the decorrelation adapter 203.

In many embodiments, the set of spatial filters applied to the second set of audio signals may be determined to have filter coefficients that correspond to coefficients of a spatial filter which is a cascade of two sets of spatial inverse filters each of which is the/an inverse filter of the spatial decorrelation filters determined by the decorrelation adapter 203.

In particular, the decorrelation adapter 203 may thus determine the weights/coefficients of a weight matrix **W**(ω) for a decorrelation filter that can decorrelate the first set of audio signals in accordance with: $y \left(ω\right) = W \left(ω\right) x \left(ω\right)$

The set of spatial filters 301 may in this case be generated to correspond to a cascaded application of two such filters, i.e. it may be arranged to correspond to: $y \left(ω\right) = {W}^{- 1} \left(ω\right) {W}^{- 1} \left(ω\right) s \left(ω\right) = {W}^{- 2} \left(ω\right) s \left(ω\right)$ where **s**(ω) represents the second set of audio signals generated by the feedback circuit 401.

Thus, in the example, the decorrelation adapter 203 may proceed to perform the adaptation as described for the example of FIG. 5 to determine suitable coefficients for a spatial decorrelation filter that would decorrelate the first set of audio signals. The determined decorrelation filter coefficients are not used directly but rather coefficients for the set of spatial filters 701 is determined from the determined coefficients. In such cases, the decorrelation adapter 203 may as part of the determination/adaptation of coefficients implement a decorrelation filter and apply this to the first set of signals (e.g. in order to determine update values from $\left[{y}_{i}\left(k, ω\right){y}_{j}^{∗}\left(k, ω\right)\right]$. However, in the specific example, such filtered signals may only be used for the adaptation process and may not be used further in the beamforming/ processing.

The approach may provide improved overall performance including an improved beamforming experience. Indeed, it can be shown that for the example in which the set of spatial filters 701 of FIG. 7 are set to coefficients corresponding to **W**⁻² then this may result in the same performance and operation as for the example of FIG. 5, and specifically that these may result in the same optimum solutions.

The audio apparatus implements a highly adaptive approach that may be particularly suitable for adapting to extract specific audio sources, such as a desired speaker. The approach may be particularly advantageous when e.g. a strong noise source is present in the audio environment being captured. The adaptive audio apparatus comprises different adaptations of respectively the set of spatial filters (via the adaptation of the decorrelation filters/decorrelation coefficients) and the adaptation of the beamformer filters. The decorrelation adapter 203 and beamform adapter 205 synergistically interwork to provide a highly advantageous and high performance adaptation to the current audio properties of the scene.

For configuration B (as illustrated in FIG. 6), it is firstly noted that the decorrelation can transform the noise covariance matrix ***R**ₙₙ*(ω) into: $W \left(ω\right) {R}_{nn} \left(ω\right) {W}^{H} \left(ω\right) = Λ \left(ω\right)$

With ***W***(ω) and ***R**ₙₙ*(ω) positive definite, their inverses exist and we can write: ${W}^{- 1} \left(ω\right) W \left(ω\right) {R}_{nn} \left(ω\right) {W}^{H} \left(ω\right) {\left({W}^{H}\left(ω\right)\right)}^{- 1} = {W}^{- 1} \left(ω\right) Λ \left(ω\right) {\left({W}^{H}\left(ω\right)\right)}^{- 1}$ ${R}_{nn} \left(ω\right) = {W}^{- 1} \left(ω\right) Λ \left(ω\right) {\left({W}^{H}\left(ω\right)\right)}^{- 1}$

If **Λ**(ω) is a scaled version of the identity matrix and can be written as ${ρ}_{nn}^{2} \left(ω\right) I$ then we get for the inverse of ***R**ₙₙ*(ω): ${R}_{nn}^{- 1} \left(ω\right) = \frac{{W}^{H} \left(ω\right) W \left(ω\right)}{{ρ}_{nn}^{2} \left(ω\right)}$

Using the decorrelator with ***W**^{H}*(ω) = ***W***(ω) we can finally write: ${W}^{2} \left(ω\right) = {ρ}_{nn}^{2} \left(ω\right) {R}_{nn}^{- 1} \left(ω\right)$ ***W***²(ω) can be seen as the inverse of a normalized covariance matrix. Note that in the decorrelation adapter 203, ***W***(ω) is calculated, whereas in the filtering part the squared matrix ***W***²(ω) is used.

We will now proof that this combination maximizes the speech-to-noise ratio in the output. First we will derive the filter coefficients after convergence like we did before for the beamformer.

At the output of the filtering part we have: $z \left(ω\right) = {f}^{H} \left(ω\right) {W}^{2} \left(ω\right) u \left(ω\right) = s \left(ω\right) {f}^{H} \left(ω\right) {W}^{2} \left(ω\right) h \left(ω\right)$ (Eq. 13)

In the update part we have: $z \left(ω\right) f \left(ω\right) = s \left(ω\right) h \left(ω\right)$ (Eq. 14)

Since z(ω) and s(ω) are scalars we can write: $f \left(ω\right) = α \left(ω\right) h \left(ω\right)$

Substitution in Eq 14 using Eq 13 gives: $α * \left(ω\right) {h}^{H} \left(ω\right) {W}^{2} \left(ω\right) h \left(ω\right) α \left(ω\right) h \left(ω\right) = h \left(ω\right)$ ${\left|α\left(ω\right)\right|}^{2} \left({h}^{H}\left(ω\right){W}^{2}\left(ω\right)h\left(ω\right)\right) = 1$ $α \left(ω\right) = \frac{a \left(ω\right)}{\sqrt{{h}^{H} \left(ω\right) {W}^{2} \left(ω\right) h \left(ω\right)}}$ with a(ω) the common all-pass. Finally we get: ${f}_{opt} \left(ω\right) = \frac{a \left(ω\right) h \left(ω\right)}{\sqrt{{h}^{H} \left(ω\right) {W}^{2} \left(ω\right) h \left(ω\right)}}$

Substitution of ***f**ₒₚₜ*(ω) into ***f^{H}***(ω)***W***²(ω)***f***(ω) gives: ${f}^{H} \left(ω\right) {W}^{2} \left(ω\right) f \left(ω\right) = \frac{{h}^{H} \left(ω\right) {W}^{2} \left(ω\right) f \left(ω\right)}{{h}^{H} \left(ω\right) {W}^{2} \left(ω\right) f \left(ω\right)} = 1$ so the constraint is met.

Next, we look at the expected value of the update after convergence: $E \left\{z*\left(ω\right)\left(u\left(ω\right)-z\left(ω\right)f\left(ω\right)\right)\right\} = 0 ,$ $E \left\{z*\left(ω\right)u\left(ω\right)\right\} = E \left\{{\left|z\left(ω\right)\right|}^{2}\right\} f \left(ω\right)$ (Eq. 15) With $z \left(ω\right) = {\left({W}^{2}\left(ω\right)u\left(ω\right)\right)}^{T} f * \left(ω\right)$ $z * \left(ω\right) = {\left({W}^{2}\left(ω\right)u\left(ω\right)\right)}^{H} f \left(ω\right)$ $z * \left(ω\right) = {u}^{H} \left(ω\right) {\left({W}^{2}\left(ω\right)\right)}^{H} f \left(ω\right) = {u}^{H} \left(ω\right) {W}^{2} \left(ω\right) f \left(ω\right)$ where we use **W**(ω) = ***W**^{H}*(ω) and (***W***²(ω))*^{H}* = ***W**^{H}*(ω)***W**^{H}*(ω) = **W**(ω)**W**(ω) = ***W***²(ω).

We then get for the update equation (Eq. 15): $\begin{matrix}E \left\{z*\left(ω\right)u\left(ω\right)\right\} = E \left\{u\left(ω\right)z*\left(ω\right)\right\} \\ = E \left\{u\left(ω\right){u}^{H}\left(ω\right){w}^{2}\left(ω\right)f\left(ω\right)\right\} \\ = {R}_{uu} \left(ω\right) {W}^{2} \left(ω\right) f \left(ω\right) = {ρ}_{zz}^{2} \left(ω\right) f \left(ω\right)\end{matrix}$ (Eq. 16) with ${R}_{uu} \left(ω\right) = E \left\{u\left(ω\right){u}^{H}\left(ω\right)\right\}$ and ${ρ}_{zz}^{2} \left(ω\right) = E \left\{{\left|z\left(ω\right)\right|}^{2}\right\}$.

What Equation 16 shows is that after convergence ***f***(ω) is an eigen vector and ${ρ}_{zz}^{2} \left(ω\right)$ the corresponding eigen value of the matrix ***R**ᵤᵤ*(ω)***W***²(ω). As before it can be shown that the solution is only stable if ${ρ}_{zz}^{2} \left(ω\right)$ is the largest eigen value.

Multiplying left and right-hand side with ***f**^{H}*(ω)***W***²(ω) we get: $\begin{matrix}{f}^{H} \left(ω\right) {W}^{2} \left(ω\right) {R}_{uu} \left(ω\right) {W}^{2} \left(ω\right) f \left(ω\right) = {ρ}_{zz}^{2} \left(ω\right) {f}^{H} \left(ω\right) {W}^{2} \left(ω\right) f \left(ω\right) \\ = {ρ}_{zz}^{2} \left(ω\right)\end{matrix}$ Note that the left-hand side contains the output power of the beamformer.

Now consider: ***Rᵤᵤ***(ω) = ***R**ₛₛ*(ω) + ***R**ₙₙ*(ω), where the adaptive decorrelator has adapted on the noise source. We then have for the output power $E \left\{{\left|z\right|}^{2}\left(ω\right)\right\}$: $E \left\{{\left|z\right|}^{2}\left(ω\right)\right\} = {f}^{H} \left(ω\right) {W}^{2} \left(ω\right) {R}_{ss} \left(ω\right) {W}^{2} \left(ω\right) f \left(ω\right) + {f}^{H} \left(ω\right) {W}^{2} \left(ω\right) {R}_{nn} \left(ω\right) {W}^{2} \left(ω\right) f \left(ω\right)$ $\begin{matrix}= {f}^{H} \left(ω\right) {W}^{2} \left(ω\right) {R}_{ss} \left(ω\right) {W}^{2} \left(ω\right) f \left(ω\right) + \\ {f}^{H} \left(ω\right) W \left(ω\right) W \left(ω\right) {R}_{nn} \left(ω\right) W \left(ω\right) W \left(ω\right) f \left(ω\right) = {f}^{H} \left(ω\right) {W}^{2} \left(ω\right) {R}_{ss} \left(ω\right) {W}^{2} \left(ω\right) f \left(ω\right) + \\ {ρ}_{nn}^{2} \left(ω\right) {f}^{H} \left(ω\right) W \left(ω\right) W \left(ω\right) f \left(ω\right) \\ = {f}^{H} \left(ω\right) {W}^{2} \left(ω\right) {R}_{ss} \left(ω\right) {W}^{2} \left(ω\right) f \left(ω\right) + {ρ}_{nn}^{2} \left(ω\right)\end{matrix}$

The noise contribution is independent from the choice of ***f***(*ω*) and thus maximizing the output of the FSB corresponds to maximizing the speech-to-noise ratio in the output, not necessarily the speech output itself.

The optimal solutions after convergence for solutions A and B are related by: ${f}_{A} \left(ω\right) = W \left(ω\right) {f}_{B} \left(ω\right) ,$

This means that the outputs for both solutions will be equal.

For solution C of FIG. 7, a matrix block may be placed after the filters in the feedback circuit 401. Here the constraint equals ***f**^{H}*(ω)**Γ**(ω)***f***(ω) =1, where **Γ**(ω) is the coherence matrix, which is equal to a normalized covariance matrix. We want to use the decorrelator again and we use $W \left(ω\right) {R}_{nn} \left(ω\right) {W}^{H} \left(ω\right) = Λ \left(ω\right) = {ρ}_{nn}^{2} \left(ω\right) I$ ${R}_{nn} \left(ω\right) = {ρ}_{nn}^{2} \left(ω\right) {W}^{- 1} \left(ω\right) {\left({W}^{H}\left(ω\right)\right)}^{- 1}$ $\frac{{R}_{nn} \left(ω\right)}{{ρ}_{nn}^{2} \left(ω\right)} = {W}^{- 2} \left(ω\right)$

Thus ***W***⁻²(ω) equals the normalized covariance matrix and we can use ***W***⁻²(ω) instead of **Γ**(ω) and the constraint becomes ***f**^{H}*(ω) ***W***⁻²(ω)***f***(ω) = 1.

Like before we find the optimal solution for the filter coefficients ***f***(ω) by considering the signal flow in the filtering part and update part.

In the filtering part we have: $z \left(ω\right) = s \left(ω\right) {f}^{H} \left(ω\right) h \left(ω\right)$ (Eq. 17) and in the update part: $z \left(ω\right) {W}^{- 2} \left(ω\right) f \left(ω\right) = s \left(ω\right) h \left(ω\right)$ (Eq. 18) $f \left(ω\right) = α \left(ω\right) {W}^{2} \left(ω\right) h \left(ω\right)$ (Eq. 19) where we use that *z*(ω) and *s*(ω) are complex scalers.

Substitution of (19) into (18), using (17) gives: $α * \left(ω\right) {h}^{H} \left(ω\right) {W}^{2} \left(ω\right) {W}^{- 2} \left(ω\right) α \left(ω\right) {W}^{2} \left(ω\right) h \left(ω\right) = h \left(ω\right)$ ${\left|α\left(ω\right)\right|}^{2} = \frac{1}{{h}^{H} \left(ω\right) {W}^{2} \left(ω\right) h \left(ω\right)}$ Using (Eq. 19) we get: ${f}_{opt} \left(ω\right) = \frac{a \left(ω\right) {W}^{2} \left(ω\right) h \left(ω\right)}{\sqrt{{h}^{H} \left(ω\right) {W}^{2} \left(ω\right) h \left(ω\right)}}$ with a(ω) allpass.

Substitution of ***fₒₚₜ***(ω) into ***f**^{H}*(ω) ***W***⁻²(ω)***f***(ω) gives: ${f}^{H} \left(ω\right) {W}^{- 2} \left(ω\right) f \left(ω\right) = \frac{{h}^{H} \left(ω\right) {W}^{2} \left(ω\right) {W}^{- 2} \left(ω\right) {W}^{2} \left(ω\right) h \left(ω\right)}{{h}^{H} \left(ω\right) {W}^{2} \left(ω\right) h \left(ω\right)} = 1$ meeting the constraint.

Finally we look at the expected value of the update after convergence $E \left\{z*\left(ω\right)\left(u\left(ω\right)-z\left(ω\right){W}^{- 2}\left(ω\right)f\left(ω\right)\right)\right\} = 0$ $E \left\{z*\left(ω\right)u\left(ω\right)\right\} = E \left\{{\left|z\left(ω\right)\right|}^{2}\right\} {W}^{- 2} \left(ω\right) f \left(ω\right)$

With *z^{*}*(ω) = ***u**^{H}**f***(ω): $E \left\{u\left(ω\right){u}^{H}\left(ω\right)\right\} f \left(ω\right) = E \left\{{\left|z\left(ω\right)\right|}^{2}\right\} {W}^{- 2} \left(ω\right) f \left(ω\right)$ ${R}_{uu} \left(ω\right) f \left(ω\right) = {ρ}_{zz}^{2} \left(ω\right) {W}^{- 2} \left(ω\right) f \left(ω\right)$ (Eq. 20) with ${R}_{uu} \left(ω\right) = E \left\{u\left(ω\right){u}^{H}\left(ω\right)\right\}$ and ${ρ}_{zz}^{2} \left(ω\right) = E \left\{{\left|z\left(ω\right)\right|}^{2}\right\}$.

Multiplying both sides with **W**²(ω) gives: $\begin{matrix}{W}^{2} \left(ω\right) {R}_{uu} \left(ω\right) f \left(ω\right) = {ρ}_{zz}^{2} \left(ω\right) {W}^{2} \left(ω\right) {W}^{- 2} \left(ω\right) f \left(ω\right) \\ = {ρ}_{zz}^{2} \left(ω\right) f \left(ω\right)\end{matrix}$

After convergence ***f***(ω) is an eigen vector and ${ρ}_{zz}^{2} \left(ω\right)$ the corresponding eigen value of the matrix ***W***²(ω) ***Rᵤᵤ***(ω). As before, it can be shown that the solution is only stable if ${ρ}_{zz}^{2} \left(ω\right)$ is the largest eigen value.

Multiplying Eq. 20 left and right with ***f**^{H}*(ω) gives: ${f}^{H} \left(ω\right) {R}_{uu} \left(ω\right) f \left(ω\right) = {ρ}_{zz}^{2} \left(ω\right) {f}^{H} \left(ω\right) {W}^{- 2} \left(ω\right) f \left(ω\right) = {ρ}_{zz}^{2} \left(ω\right)$ Note that the left-hand side contains the output power of the FSB.

Now consider: ***R**ᵤᵤ*(ω) = ***R**ₛₛ*(ω) + ***R**ₙₙ*(ω), where the adaptive decorrelator has adapted on the noise source. We then have for the output power $E \left\{{\left|z\right|}^{2}\left(ω\right)\right\}$: $\begin{matrix}E \left\{{\left|z\right|}^{2}\left(ω\right)\right\} = {f}^{H} \left(ω\right) {R}_{uu} \left(ω\right) f \left(ω\right) = {f}^{H} \left(ω\right) {R}_{ss} \left(ω\right) f \left(ω\right) + {f}^{H} \left(ω\right) {R}_{nn} \left(ω\right) f \left(ω\right) \\ = {f}^{H} \left(ω\right) {R}_{ss} \left(ω\right) f \left(ω\right) + {ρ}_{nn}^{2} \left(ω\right) {f}^{H} \left(ω\right) {W}^{- 2} \left(ω\right) f \left(ω\right) \\ = {f}^{H} \left(ω\right) {R}_{ss} \left(ω\right) f \left(ω\right) + {ρ}_{nn}^{2} \left(ω\right)\end{matrix}$

Maximizing the output of the FSB corresponds to maximizing the speech-to-noise ratio in the output, not necessarily the speech output itself.

The optimal solutions after convergence for solutions C and B are related by ***f**_{C}*(ω) = **W**²(ω)***f**_{B}*(ω).

This means that the outputs for both solutions will be equal. Thus, the different configurations/solutions can be summarized by:

| Solution | System output *z*(*ω*) | Optimal coefficients ***f***ₒₚₜ(ω) |
|---|---|---|
| A | $a * \left(ω\right) \sqrt{{h}^{H} \left(ω\right) {W}^{2} \left(ω\right) h \left(ω\right)} s \left(ω\right)$ | $\frac{a \left(ω\right) W \left(ω\right) h \left(ω\right)}{\sqrt{{h}^{H} \left(ω\right) {W}^{2} \left(ω\right) h \left(ω\right)}}$ |
| B | $a * \left(ω\right) \sqrt{{h}^{H} \left(ω\right) {W}^{2} \left(ω\right) h \left(ω\right)} s \left(ω\right)$ | $\frac{a \left(ω\right) h \left(ω\right)}{\sqrt{{h}^{H} \left(ω\right) {W}^{2} \left(ω\right) h \left(ω\right)}}$ |
| C | $a * \left(ω\right) \sqrt{{h}^{H} \left(ω\right) {W}^{2} \left(ω\right) h \left(ω\right)} s \left(ω\right)$ | $\frac{a \left(ω\right) {W}^{2} \left(ω\right) h \left(ω\right)}{\sqrt{{h}^{H} \left(ω\right) {W}^{2} \left(ω\right) h \left(ω\right)}}$ |

As can be seen, by selecting the coefficients appropriately, the exact same (optimal) beamform output audio signal can be generated.

However, as can be seen, the coefficients that are selected for the set of spatial filters to achieve this output may be different.

The choice of the approach to use will depend on the preferences and requirements of the individual embodiment.

An advantage of solution A is that the interaction between the decorrelator and beamformer is reduced in the sense that the synergistic effect can be achieved with reduced modifications of the beamformer, feedback circuit, and beamform adapter.

An advantage of solution B is that if you want to calculate the Direction of Arrival (DOA) of an audio source using the beamformer coefficients, then this is easier to do for this configuration.

For example, an approach for calculating a DOA is described in US 6774934 for a "normal" beamformer with a speech source with possibly uncorrelated equivariant noise added. For this use case the optimal coefficients are given by: ${f}_{opt} \left(ω\right) = \frac{a \left(ω\right) h \left(ω\right)}{\sqrt{{h}^{H} \left(ω\right) h \left(ω\right)}}$

Part of the procedure is that the cross-power spectrum is calculated for at least one pair of filter coefficients, e.g. *f*₁(ω) and *f*₂(ω). This gives: ${f}_{1} \left(ω\right) {f}_{2}^{∗} \left(ω\right) = \frac{{h}_{1} \left(ω\right) {h}_{2}^{∗} \left(ω\right)}{{h}^{H} \left(ω\right) h \left(ω\right)}$ where we use *a*(ω)*a*^{*}(ω) = 1, since a is an allpass.

The phase difference, rather than the amplitude, is the more significant factor. This means that for solution B we can directly use the beamformer coefficients, but for methods A and C we pre-multiply the coefficients with **W⁻¹**(ω) and ***W***⁻²(ω) respectively.

The different configurations may accordingly result in the exact same beamform output audio signal being generated. Accordingly, the same compensating frequency response may also advantageously be applied by the equalizer 105. Suitable approaches for determining a suitable compensating frequency response from the beamform and decorrelation parameters may be determined using the same considerations and approach as for configuration A.

For configuration B, the magnitude of the compensating frequency response may by the equalization adapter 107 be determined as: $\left|{h}_{eq}\left(ω\right)\right| = \sqrt{{f}_{opt}^{H} \left(ω\right) {f}_{opt} \left(ω\right)}$

In this case we have ${f}_{opt} \left(ω\right) = \frac{a \left(ω\right) h \left(ω\right)}{\sqrt{{h}^{H} \left(ω\right) {W}^{2} \left(ω\right) h \left(ω\right)}}$

Substitution into the previous equation for |*h_{eq}*(ω)| then yields: $\left|{h}_{eq}\left(ω\right)\right| = \sqrt{\frac{{h}^{H} \left(ω\right) h \left(ω\right)}{{h}^{H} \left(ω\right) {W}^{2} \left(ω\right) h \left(ω\right)}}$ which is the desired magnitude compensating frequency response as previously shown.

It should be noted that in this case, the compensating frequency response depends only on the beamform parameters and are not dependent on the decorrelation parameters.

For configuration C, the magnitude of the compensating frequency response may by the equalization adapter 107 be determined as: $\left|{h}_{eq}\left(ω\right)\right| = \sqrt{{f}_{opt}^{H} \left(ω\right) {W}^{- 2} \left(ω\right) {W}^{- 2} \left(ω\right) {f}_{opt} \left(ω\right)}$

In this case we have ${f}_{opt} \left(ω\right) = \frac{a \left(ω\right) {W}^{2} \left(ω\right) h \left(ω\right)}{\sqrt{{h}^{H} \left(ω\right) {W}^{2} \left(ω\right) h \left(ω\right)}}$

Substitution into the previous equation for |*h_{eq}*(ω)| then yields: $\left|{h}_{eq}\left(ω\right)\right| = \sqrt{\frac{a * \left(ω\right) {h}^{H} \left(ω\right) {w}^{2} \left(ω\right) {w}^{- 2} \left(ω\right) {w}^{- 2} \left(ω\right) a \left(ω\right) {W}^{2} \left(ω\right) h \left(ω\right)}{{h}^{H} \left(ω\right) {W}^{2} \left(ω\right) h \left(ω\right)}}$ $\left|{h}_{eq}\left(ω\right)\right| = \sqrt{\frac{{h}^{H} \left(ω\right) h \left(ω\right)}{{h}^{H} \left(ω\right) {W}^{2} \left(ω\right) h \left(ω\right)}}$ which is the desired magnitude compensating frequency response as previously shown.

In many embodiments, the audio apparatus may be arranged to adapt the different adaptations at different times. Thus, the decorrelation adapter 203 and the beamform adapter 205 may be controlled to perform their respective adaptation at different time periods, and in many embodiments these may be non-overlapping. Thus, at a given time, either the decorrelation adapter 203 or the beamform adapter 105 may be adapting but not both (although for some periods neither may be adapted).

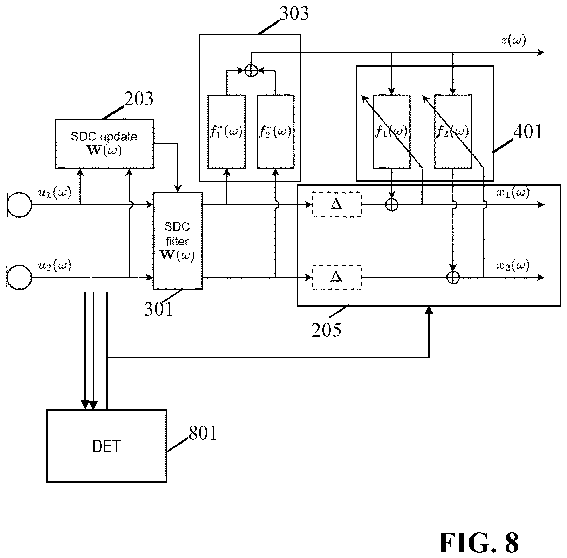

For example, as illustrated in FIG. 8, the audio apparatus of FIG. 5 (or correspondingly of FIG. 6 or 7) may include an audio detector 801 which is arranged to detect when an audio source is active and when it is not. The audio detector 801 may specifically be arranged to divide the time into (at least) a set of active time intervals during which an audio source is active and a set of inactive time intervals during which the audio source is not active. The audio source may specifically be a desired audio source, such as specifically a desired speaker.

In some embodiments, a low complexity audio detection may be used to determine whether a source is active or not. For example, the audio apparatus may be used to extract the dominant audio source in the environment, such as for example the strongest speaker. For example, typically for teleconferencing applications, only one person will be speaking at a time and the audio apparatus may be used to extract the speech of the current speaker from background or ambient noise.

The audio detector 801 may for example in such applications simply detect the audio source activity based on a level/ energy being above a given threshold. If the signal level is above the given threshold (which may e.g. be a dynamic threshold that is set based on a longer time averaged signal level), the audio detector 801 may consider the audio source/speaker to be active and otherwise it may consider the audio source/speaker to not be active. Thus, the audio detector 801 may divide the time into active time intervals when the captured audio is above a threshold (due to the audio source is active) and non-active time intervals when the signal level is below the threshold (due to the audio source not being active).

In many embodiments, more complex detections may be used and indeed techniques may be used that separate between different audio sources. For example, in many embodiments the detection may include a consideration of whether the audio signal has desired/expected properties matching the specific audio source. For example, the audio detector 801 may differentiate between speech and other types of audio based on evaluating whether the captured audio has properties matching speech.

It will be appreciated that many different techniques and algorithms are known for speech/voice activity detection, and more generally for detecting that an audio source is active, and that any suitable approach may be used without detracting from the invention.

In some embodiments, a trained artificial neural network may be used, and it has in practice been found that effective speech/voice activity detection (and/or noise detection) can be performed. The artificial neural network may be trained with speech and all types of non-speech and may for each frame provide an indication whether it is noise or speech.

In many embodiments, the detection may be relatively fast and the audio detector 801 may be arranged to designate relatively short time intervals as active or non-active time intervals. For example, in some embodiments, the audio detector 801 may be arranged to detect silent pauses/intervals during normal speech and designate such intervals as non-active time intervals. For example, time intervals less than e.g. 5 msec, 10 msec, or 20 msec may in some embodiments be identified/designated as active or non-active time intervals.

In many embodiments, the audio detector 801 may directly detect activity for an audio source based on the received microphone signals/ the first set of audio signals/ the beamformer input signals / beamform output audio signal. For example, the total captured audio energy may be determined and compared to a threshold. However, in other embodiments other signals may be considered, such as e.g. the second set of audio signals. In many embodiments, the audio detector 801 may base the activity detection on the generated beamform output audio signal. For example, level detection or speech detection may be applied directly to the beamform output audio signal. This may in many embodiments provide improved performance as the output signal may specifically be generated to focus on the desired signal, such as the desired speaker.

The audio detector 801 may be arranged to control the adaptation based on the audio source activity detection and specifically the adaption of the decorrelation coefficients and/or of the beamform filter coefficients may be different in active time intervals than in inactive time intervals.

Indeed, in some embodiments, the adaptation of the decorrelation coefficients may not be performed during the active time intervals but only during the inactive time intervals. The audio detector 801 may specifically seek to detect whether a desired or wanted audio source/speaker is active. It may further control the decorrelation adapter 203 to adapt the decorrelation coefficients only when this audio source is not active. Thus, the decorrelation adapter 203 may be arranged to adapt to provide decorrelation filters that seek to decorrelate the unwanted audio. Thus, rather than update the decorrelation filters to be a decorrelation of the entire captured audio, it will be aimed at adapting to reduce correlation of the undesired audio. Such an approach may provide a very efficient and improved operation and performance in many situations. The decorrelation approach for the non-desired audio may allow improved beamforming with improved rejection of the undesired audio by the beamforming while allowing the beamforming to provide efficient and high performance extraction of the wanted signal.

In some embodiments, the decorrelation adapter 203 may be arranged to adapt the decorrelation coefficients in both the active time intervals and the inactive time intervals but with the adaption rate being higher during the inactive time intervals than during the active time intervals. Thus, rather than only adapting the decorrelation coefficients during the inactive time interval, there may also be some adaptation during the active time intervals but with this adaptation being slower, e.g., by a factor of no less than 2,5,10 or 100. This may be advantageous in some scenarios, such as for example where the active time intervals are much longer than the inactive time intervals. In some embodiments, the update rate during the active time intervals and/or the inactive time intervals may be dynamically adapted depending on e.g., properties of the time intervals or the input signals. For example, the decorrelation adapter 203 may switch between only updating during the inactive time intervals to also updating (at a lower rate) during the active time intervals if the duration of the active time intervals exceed a given duration.

In many embodiments, the adaptation of the beamforming filters may not be performed during the inactive time intervals but only during the active time intervals. The audio detector 801 may specifically seek to detect whether a desired or wanted audio source/speaker is active and control the beamform adapter 205 to adapt the beamform filters only when this audio source is active. Thus, the beamform adapter 205 is arranged to specifically adapt the beamforming to specifically (virtually) form a beam towards the desired audio source.

In some embodiments, the beamform adapter 205 may be arranged to adapt the beamformer coefficients in both the active time intervals and the inactive time intervals but with the adaption rate being higher during the active time intervals than during the inactive time intervals. Thus, rather than only adapting the beamform filters during the active time interval, there may also be some adaptation during the inactive time intervals but with this adaptation being slower, e.g. by a factor of no less than 2,5,10 or 100. This may be advantageous in some scenarios, such as for example where the audio detector 801 is set to provide a detection with a very low risk of false detection of the active audio source such that the risk of not detecting the audio source being active is relatively high. In such cases, it may be desirable to still adapt during the inactive time interval but with an update rate that is (typically) much lower. Thus, a low update rate may be used during time intervals when the wanted source may or may not be active and with a high update rate being used during time intervals when the wanted source is almost certainly present.

In many embodiments the audio apparatus may be arranged to adapt the decorrelation coefficients (only) during the inactive time intervals and to adapt the beamforming filters (only) during the active time intervals. This may provide highly efficient performance and in particular may provide substantially improved extraction/separation of a desired audio source/speaker in the presence of noise/ undesired audio, such as specifically a dominant and correlated noise source.

In many practical applications, such as many speech capture and processing applications, the adaptation control of both the beamforming and decorrelation is important for the effective operation of the audio apparatus. It may be desired for the beamformer to adapt on the speech, which by nature is not always active, and the decorrelation on the noise only part. In use cases where the noise is continuously available, the beamformer can only adapt when there is also noise present. In case the noise is uncorrelated, or the noise is decorrelated by the decorrelation, the noise does not influence the adaptation if the noise is equivariant. If the noise is not equivariant, the beamformer will diverge during noise only, but the beamformer can often quickly (almost unnoticeably) adjust to the desired speaker if near-end becomes active. Depending on the application, either no further adaptation control is used, such that the beamformer can quickly find new sources, or a voice-activity detector is used, which can vary from a simple energy-based detector until more sophisticated detectors that also use speech characteristics based on pitch for example.

In the above, the description focused on a scenario where the active time intervals are wanted/speech audio source active time intervals and the inactive time intervals are unwanted source/noise/interference active time intervals. In this case, the adaptation rate for the beamformer filters is higher during the active time intervals than during the inactive time intervals, and specifically the adaptation rate for the beamformer filters may be performed only during the active time intervals and not during the inactive time intervals. Equivalently, the adaptation rate for the decorrelation coefficients is higher during the inactive time intervals than during the active time intervals, and specifically the adaptation rate for the filters may be performed only during the inactive time intervals and not during the active time intervals.

Such time intervals may for example be determined directly by the use of a speech detector which detects and determines the speech active time intervals, which may be considered as the active time intervals. The remaining time intervals, i.e. the non- speech active time intervals may be considered as the inactive time intervals.

In some embodiments, a detection of undesired audio properties may be used, such as specifically a detection of the activity of an interferer or noise source. For example, detection of activity of an undesired audio source may be used, e.g., a music detector, silence detector, specific noises detector. In such cases, the time intervals detected may be considered as the inactive time intervals. The remaining time intervals may be considered as the active time intervals.

It will be appreciated that if instead, active time intervals were considered to correspond to time intervals in which an undesired audio source is active and inactive time intervals were considered to correspond to time intervals in which the undesired audio source is not active, then the previously described adaptation would be reversed (adaptation rate of filters would be higher during inactive time intervals, adaptation rate of decorrelation coefficients would be higher during active time intervals, and specifically in many embodiments adaptation of beamformer filters would only be in inactive time intervals and adaptation of decorrelation coefficients would only be in active time intervals).

In the approach, the decorrelation function and the beamforming function is dynamically updated, and correspondingly the equalizer 105 is dynamically adapted to have a variable compensating frequency response that follows the adaptations of the decorrelation and beamforming. In many embodiments, the operation is performed in segments or blocks and for each block, new and updated parameters are determined.

However, changing the compensating frequency response abruptly has been found to provide audio artefacts in many scenarios and applications. In many embodiments, the equalization adapter 107 is arranged to change the compensating frequency response gradually and without sudden and abrupt substantial changes in the compensating frequency response. Specifically, the compensating frequency response is not merely changed between different segments but a gradual change during a segment is implemented.

In many embodiments, the equalization adapter 107 may be arranged to interpolate between a current and a new compensating frequency response with the interpolation gradually changing from the former towards the latter. Specifically, the beamform output audio signal may be subjected to both a current and new frequency equalization, and specifically samples of the beamform output audio signal may be filtered by both the current and the new compensating frequency responses. Accordingly, samples are generated for two signals corresponding to respectively the current and the new frequency equalization. The equalizer 105 may then generate the output signal as an interpolation between these, and specifically the samples of the output signal may be generated as a weighted combination of the samples (at the same sample instant) of the two signals. The weighting may then be gradually changed from a higher weighting of the samples for the current frequency equalization towards a higher weighting of the samples of the new frequency equalization. The rate of change of the combination/interpolation may be selected to provide suitable performance for the specific embodiment.

The equalization adapter 107 may thus control the equalizer 105 to transition from one frequency equalization/compensating frequency response to another frequency equalization/compensating frequency response by determining intermediate samples of the output signal for the two frequency equalizations, and then generating samples of the output signal as a weighted combination of the intermediate samples for the different frequency equalizations, where the equalization adapter 107 is then, during a transition time interval, arranged to gradually change the relative weighting of samples of the different frequency equalizations.

It may thus be preferred to implement a smooth transition when *h_{eq}*(ω) is updated. Good results can be obtained by, for a transition frame (a block of typically 256 samples), calculating the output for both the old and new *h_{eq}*(ω) and then calculating the output with a smooth transition.

Denoting the samples of the frame processed with old *h_{eq}*(ω) as "inold" and the frame with new *h_{eq}*(ω) as "innew", then the output can be determined by the following approach (in pseudo code) with a = 1 and e.g. β = 0.01 as start values:

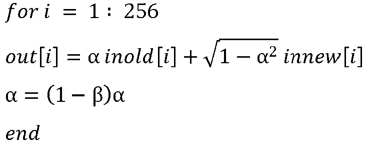

Although the previous description has focused on an adaptive spatial decorrelation being performed by an adaptive spatial decorrelator 301, it will be appreciated that in other embodiments, a non-adaptive spatial decorrelation may be performed.

The audio apparatus(s) may specifically be implemented in one or more suitably programmed processors. The different functional blocks may be implemented in separate processors and/or may, e.g., be implemented in the same processor. An example of a suitable processor is provided in the following.

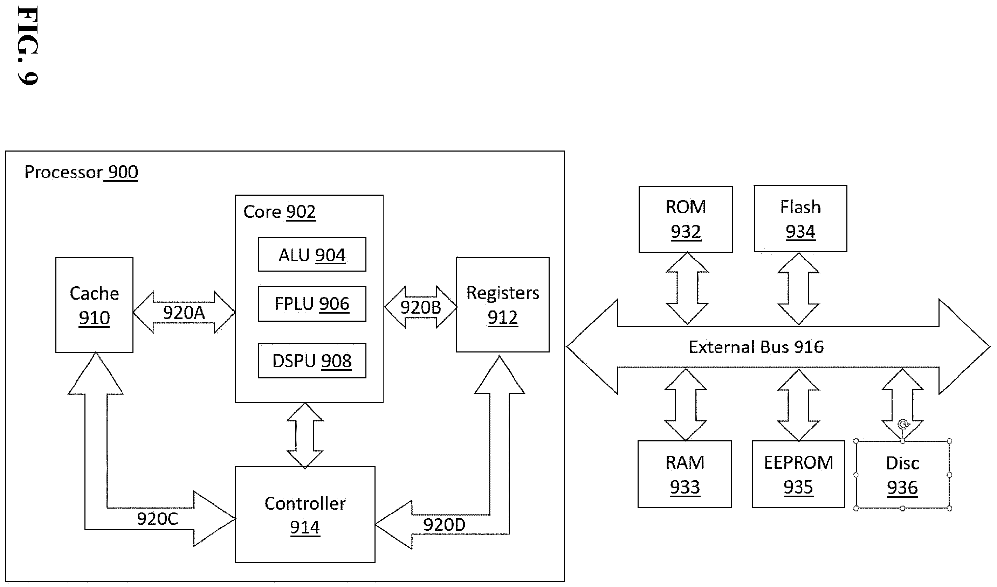

FIG. 9 is a block diagram illustrating an example processor 900 according to embodiments of the disclosure. Processor 900 may be used to implement one or more processors implementing an apparatus as previously described or elements thereof (including in particular one more artificial neural network). Processor 900 may be any suitable processor type including, but not limited to, a microprocessor, a microcontroller, a Digital Signal Processor (DSP), a Field ProGrammable Array (FPGA) where the FPGA has been programmed to form a processor, a Graphical Processing Unit (GPU), an Application Specific Integrated Circuit (ASIC) where the ASIC has been designed to form a processor, or a combination thereof.

The processor 900 may include one or more cores 902. The core 902 may include one or more Arithmetic Logic Units (ALU) 904. In some embodiments, the core 902 may include a Floating Point Logic Unit (FPLU) 906 and/or a Digital Signal Processing Unit (DSPU) 908 in addition to or instead of the ALU 904.

The processor 900 may include one or more registers 912 communicatively coupled to the core 902. The registers 912 may be implemented using dedicated logic gate circuits (e.g., flip-flops) and/or any memory technology. In some embodiments the registers 912 may be implemented using static memory. The register may provide data, instructions and addresses to the core 902.

In some embodiments, processor 900 may include one or more levels of cache memory 910 communicatively coupled to the core 902. The cache memory 910 may provide computer-readable instructions to the core 902 for execution. The cache memory 910 may provide data for processing by the core 902. In some embodiments, the computer-readable instructions may have been provided to the cache memory 910 by a local memory, for example, local memory attached to the external bus 916. The cache memory 910 may be implemented with any suitable cache memory type, for example, Metal-Oxide Semiconductor (MOS) memory such as Static Random Access Memory (SRAM), Dynamic Random Access Memory (DRAM), and/or any other suitable memory technology.

The processor 900 may include a controller 914, which may control input to the processor 900 from other processors and/or components included in a system and/or outputs from the processor 900 to other processors and/or components included in the system. Controller 914 may control the data paths in the ALU 904, FPLU 906 and/or DSPU 908. Controller 914 may be implemented as one or more state machines, data paths and/or dedicated control logic. The gates of controller 914 may be implemented as standalone gates, FPGA, ASIC or any other suitable technology.

The registers 912 and the cache 910 may communicate with controller 914 and core 902 via internal connections 920A, 920B, 920C and 920D. Internal connections may be implemented as a bus, multiplexer, crossbar switch, and/or any other suitable connection technology.

Inputs and outputs for the processor 900 may be provided via a bus 916, which may include one or more conductive lines. The bus 916 may be communicatively coupled to one or more components of processor 900, for example the controller 914, cache 910, and/or register 912. The bus 916 may be coupled to one or more components of the system.

The bus 916 may be coupled to one or more external memories. The external memories may include Read Only Memory (ROM) 932. ROM 932 may be a masked ROM, Electronically Programmable Read Only Memory (EPROM) or any other suitable technology. The external memory may include Random Access Memory (RAM) 933. RAM 933 may be a static RAM, battery backed up static RAM, Dynamic RAM (DRAM) or any other suitable technology. The external memory may include Electrically Erasable Programmable Read Only Memory (EEPROM) 935. The external memory may include Flash memory 934. The External memory may include a magnetic storage device such as disc 936. In some embodiments, the external memories may be included in a system.

It will be appreciated that the above description for clarity has described embodiments of the invention with reference to different functional circuits, units and processors. However, it will be apparent that any suitable distribution of functionality between different functional circuits, units or processors may be used without detracting from the invention. For example, functionality illustrated to be performed by separate processors or controllers may be performed by the same processor or controllers. Hence, references to specific functional units or circuits are only to be seen as references to suitable means for providing the described functionality rather than indicative of a strict logical or physical structure or organization.

The invention can be implemented in any suitable form including hardware, software, firmware or any combination of these. The invention may optionally be implemented at least partly as computer software running on one or more data processors and/or digital signal processors. The elements and components of an embodiment of the invention may be physically, functionally and logically implemented in any suitable way. Indeed, the functionality may be implemented in a single unit, in a plurality of units or as part of other functional units. As such, the invention may be implemented in a single unit or may be physically and functionally distributed between different units, circuits and processors.

Although the present invention has been described in connection with some embodiments, it is not intended to be limited to the specific form set forth herein. Rather, the scope of the present invention is limited only by the accompanying claims. Additionally, although a feature may appear to be described in connection with particular embodiments, one skilled in the art would recognize that various features of the described embodiments may be combined in accordance with the invention. In the claims, the term comprising does not exclude the presence of other elements or steps.

Furthermore, although individually listed, a plurality of means, elements, circuits or method steps may be implemented by, e.g., a single circuit, unit or processor. Additionally, although individual features may be included in different claims, these may possibly be advantageously combined, and the inclusion in different claims does not imply that a combination of features is not feasible and/or advantageous. Also, the inclusion of a feature in one category of claims does not imply a limitation to this category but rather indicates that the feature is equally applicable to other claim categories as appropriate. Furthermore, the order of features in the claims do not imply any specific order in which the features must be worked and in particular the order of individual steps in a method claim does not imply that the steps must be performed in this order. Rather, the steps may be performed in any suitable order. In addition, singular references do not exclude a plurality. Thus, references to "a", "an", "first", "second" etc. do not preclude a plurality. Reference signs in the claims are provided merely as a clarifying example shall not be construed as limiting the scope of the claims in any way.

## Claims

1. An audio apparatus comprising:
a receiver (101) arranged to receive a first set of audio signals, the first set of audio signals comprising audio signals capturing audio of a scene from different positions;
an audio beamformer (103) arranged to generate a beamform output audio signal from the first set of audio signals, the audio beamformer (103) comprising:
a signal processor (201) arranged to generate the beamform output audio signal from a signal processing of the first set of audio signals, the signal processing including spatial beamforming and spatial decorrelation for the first set of audio signals, the spatial decorrelation depending on a set of decorrelation parameters and the spatial beamforming depending on a set of beamform parameters, the beamforming including a combination of audio signals, the combination generating the beamform output audio signal and including at least one of a filtering and a weighting of the audio signals, the beamform parameters being parameters describing at least one of the filtering and the weighting of audio signals of the combination;
a beamform adapter (205) arranged to adapt the set of beamform parameters dependent on the beamform output audio signal; and
an equalizer (105) arranged to apply a frequency equalization to the beamform output audio signal to generate an output signal;
**characterised by**:
an equalization adapter (107) arranged to adapt the frequency equalization dependent on the set of beamform parameters.

2. The audio apparatus of claim 1 wherein the equalization adapter (107) is arranged to adapt the frequency equalization dependent on the set of decorrelation parameters.

3. The audio apparatus of claim 1 wherein the signal processor (201) comprises:
a spatial decorrelator (301) arranged to receive the first set of audio signals and to generate a decorrelated first set of audio signals by performing the spatial decorrelation; and
a beamform circuit (303) arranged to perform the spatial beamforming by combining the decorrelated first set of audio signals, the combining depending on the set of beamform parameters.

4. The audio apparatus of any previous claim wherein the equalization adapter (107) is arranged to adapt the frequency equalization to have a minimum phase frequency response.

5. The audio apparatus of any previous claim wherein the equalization adapter (107) is arranged to adapt the frequency equalization to have a low pass frequency response.

6. The audio apparatus of any previous claim wherein the equalization adapter (107) is arranged to transition from a first frequency equalization to a second frequency equalization by determining first intermediate samples of the output signal for the first frequency equalization and second intermediate samples of the output signal for the second frequency equalization, and generating samples of the output signal as a weighted combination of the first intermediate samples and the second intermediate samples, the equalization adapter (107) being arranged to gradually change the relative weighting of the first intermediate samples and the second intermediate samples during a transition time interval.

7. The audio apparatus of claim 1 wherein the spatial decorrelation is an adaptive spatial decorrelation and the audio apparatus further comprises:
a decorrelation adapter (203) arranged to adapt the set of decorrelation parameters dependent on the first set of audio signals.

8. The audio apparatus of claim 7 further comprising an audio detector (801) arranged to determine a set of active time intervals during which an audio source is active and a set of inactive time intervals during which the audio source is not active; and wherein at least one of the adaption of the set of beamform parameters and the adaptation of the set of decorrelation parameters (203) is different for the set of active time intervals and the set of inactive time intervals.

9. The audio apparatus of claim 7 wherein the signal processor (201) comprises:
a first set of filters (303) arranged to filter the first set of audio signals, and
a combiner (303) arranged to combine outputs of the first set of filters (303) to generate the beamform output audio signal;
a feedback circuit (401) comprising a second set of filters arranged to generate a second set of audio signals from a filtering of the beamform output audio signal, each filter of the second set of filters having a frequency response being a complex conjugate of a filter of the first set of filters (303);
a first set of spatial filters (301, 601, 701) arranged to apply a first spatial filtering to at least one of the first set of audio signals and the second set of audio signals, the first set of spatial filters (301, 601, 701) having coefficients determined from decorrelation coefficients comprised in the decorrelation parameters;
and wherein
the beamform adapter (205) is arranged to adapt the first set of filters (303) and the second set of filters in response to a comparison of the first set of audio signals and the second set of audio signals; and
the decorrelation adapter (203) is arranged to determine decorrelation coefficients for a set of spatial decorrelation filters generating decorrelated output signals from the first set of audio signals, the decorrelation adapter (203) being arranged to adapt the decorrelation coefficients in response to an update value determined from the first set of audio signals.

10. The audio apparatus of claim 9 wherein the first set of spatial filters (301) is arranged to filter the first set of audio signals.

11. The audio apparatus of claim 9 or 10 wherein the first set of filters (303) is arranged to filter the first set of audio signals after filtering by the first set of spatial filters (601) and the beamform adapter (205) is arranged to perform the comparison using the first set of audio signals before filtering by the first set of spatial filters (601).

12. The audio apparatus of claim 9 wherein the first set of spatial filters (701) is arranged to filter the second set of audio signals.

13. The audio apparatus of any previous claim wherein the decorrelation adapter (203) is arranged to determine the adaptive spatial decorrelation as a set of spatial decorrelation filters, each output audio signal of a filter of the set of spatial decorrelation filters being linked with one input audio signal of the first set of audio signals, by performing the steps of:
segmenting the first set of audio signals into time segments, and for at least some time segments performing the steps of:
generating a frequency bin representation of the first set of audio signals, each frequency bin of the frequency bin representation of the first set of audio signals comprising a frequency bin value for each of the audio signals of the first set of audio signals;
generating a frequency bin representation of a set of output signals, each frequency bin of the frequency bin representation of the set of output signals comprising a frequency bin value for each of the output signals, the frequency bin value for a given output signal of the set of output signals for a given frequency bin being generated as a weighted combination of frequency bin values of the first set of audio signals for the given frequency bin, the weighted combination having the decorrelation coefficients as weights;
updating a first weight for a contribution to a first frequency bin value of a first frequency bin for a first output signal linked with a first input audio signal from a second frequency bin value of the first frequency bin for a second input audio signal linked to a second output signal in response to a correlation measure between a first previous frequency bin value of the first output signal for the first frequency bin and a second previous frequency bin value of the second output signal for the first frequency bin.

14. The audio apparatus of claim 13 wherein the decorrelation adapter (203) is arranged to update the first weight in response to a product of a first value and a second value, the first value being one of the first previous frequency bin value and the second previous frequency bin value and the second value being a complex conjugate of the other of the first previous frequency bin value and the second previous frequency bin value.

15. A method of operation for an audio apparatus, the method comprising:
receiving a first set of audio signals, the first set of audio signals comprising audio signals capturing audio of a scene from different positions;
generating a beamform output audio signal from the first set of audio signals, wherein generating the beamform output audio signal comprises:
generating the beamform output audio signal from a signal processing of the first set of audio signals, the signal processing including spatial beamforming and adaptive spatial decorrelation for the first set of audio signals, the adaptive spatial decorrelation depending on a set of decorrelation parameters and the spatial beamforming depending on a set of beamform parameters, the beamforming including a combination of audio signals, the combination generating the beamform output audio signal and including at least one of a filtering and a weighting of the audio signals, the beamform parameters being parameters describing at least one of the filtering and the weighting of audio signals of the combination;
adapting the set of decorrelation parameters dependent on the first set of audio signals;
adapting the set of beamform parameters dependent on the beamform output audio signal; and
applying a frequency equalization to the beamform output audio signal to generate an output signal;
**characterised by**:
adapting the frequency equalization dependent on the set of beamform parameters.

16. A computer program product comprising computer program code means adapted to perform all the steps of claim 15 when said program is run on a computer.

## Patentansprüche

1. Audiovorrichtung, umfassend:
einen Empfänger (101), der dazu eingerichtet ist, einen ersten Satz von Audiosignalen zu empfangen, wobei der erste Satz von Audiosignalen Audiosignale umfasst, die Audio einer Szene von verschiedenen Positionen erfassen;
einen Audiostrahlformer (103), der dazu eingerichtet ist, ein Strahlformausgangsaudiosignal aus dem ersten Satz von Audiosignalen zu erzeugen, wobei der Audiostrahlformer (103) umfasst:
einen Signalprozessor (201), der dazu eingerichtet ist, das Strahlformausgangsaudiosignal aus einer Signalverarbeitung des ersten Satzes von Audiosignalen zu erzeugen, wobei die Signalverarbeitung räumliche Strahlformung und räumliche Dekorrelation für den ersten Satz von Audiosignalen beinhaltet, wobei die räumliche Dekorrelation von einem Satz von Dekorrelationsparametern abhängt und die räumliche Strahlformung von einem Satz von Strahlformparametern abhängt, wobei die Strahlformung eine Kombination von Audiosignalen beinhaltet, wobei die Kombination das Strahlformausgangsaudiosignal erzeugt und eine Filterung und/oder eine Gewichtung der Audiosignale beinhaltet, wobei die Strahlformparameter Parameter sind, die die Filterung und/oder die Gewichtung von Audiosignalen der Kombination beschreiben;
einen Strahlformadapter (205), der dazu eingerichtet ist, den Satz von Strahlformparametern in Abhängigkeit von dem Strahlformausgangsaudiosignal anzupassen; und
einen Entzerrer (105), der dazu eingerichtet ist, eine Frequenzentzerrung auf das Strahlformausgangsaudiosignal anzuwenden, um ein Ausgangssignal zu erzeugen;
**gekennzeichnet durch**:
einen Entzerrungsadapter (107), der dazu eingerichtet ist, die Frequenzentzerrung in Abhängigkeit von dem Satz von Strahlformparametern anzupassen.

2. Audiovorrichtung nach Anspruch 1, wobei der Entzerrungsadapter (107) dazu eingerichtet ist, die Frequenzentzerrung in Abhängigkeit von dem Satz von Dekorrelationsparametern anzupassen.

3. Audiovorrichtung nach Anspruch 1, wobei der Signalprozessor (201) umfasst:
einen räumlichen Dekorrelator (301), der dazu eingerichtet ist, den ersten Satz von Audiosignalen zu empfangen und einen dekorrelierten ersten Satz von Audiosignalen durch Durchführen der räumlichen Dekorrelation zu erzeugen; und
eine Strahlformschaltung (303), die dazu eingerichtet ist, die räumliche Strahlformung durch Kombinieren des dekorrelierten ersten Satzes von Audiosignalen durchzuführen, wobei das Kombinieren von dem Satz von Strahlformparametern abhängt.

4. Audiovorrichtung nach einem der vorhergehenden Ansprüche, wobei der Entzerrungsadapter (107) dazu eingerichtet ist, die Frequenzentzerrung so anzupassen, dass sie eine minimale Phasen-Frequenzantwort aufweist.

5. Audiovorrichtung nach einem der vorhergehenden Ansprüche, wobei der Entzerrungsadapter (107) dazu eingerichtet ist, die Frequenzentzerrung so anzupassen, dass sie eine Tiefpass-Frequenzantwort aufweist.

6. Audiovorrichtung nach einem der vorhergehenden Ansprüche, wobei der Entzerrungsadapter (107) dazu eingerichtet ist, von einer ersten Frequenzentzerrung zu einer zweiten Frequenzentzerrung überzugehen, indem erste Zwischenabtastungen des Ausgangssignals für die erste Frequenzentzerrung und zweite Zwischenabtastungen des Ausgangssignals für die zweite Frequenzentzerrung bestimmt werden, und Abtastungen des Ausgangssignals als eine gewichtete Kombination der ersten Zwischenabtastungen und der zweiten Zwischenabtastungen zu erzeugen, wobei der Entzerrungsadapter (107) eingerichtet ist, die relative Gewichtung der ersten Zwischenabtastungen und der zweiten Zwischenabtastungen während eines Übergangszeitintervalls allmählich zu ändern.

7. Audiovorrichtung nach Anspruch 1, wobei die räumliche Dekorrelation eine adaptive räumliche Dekorrelation ist und die Audiovorrichtung ferner umfasst:
einen Dekorrelationsadapter (203), der dazu eingerichtet ist, den Satz von Dekorrelationsparametern in Abhängigkeit von dem ersten Satz von Audiosignalen anzupassen.

8. Audiovorrichtung nach Anspruch 7, ferner umfassend einen Audiodetektor (801), der dazu eingerichtet ist, einen Satz von aktiven Zeitintervallen, während denen eine Audioquelle aktiv ist, und einen Satz von inaktiven Zeitintervallen, während denen die Audioquelle nicht aktiv ist, zu bestimmen; und wobei die Anpassung des Satzes von Strahlformparametern und/oder die Anpassung des Satzes von Dekorrelationsparametern (203) für den Satz von aktiven Zeitintervallen und den Satz von inaktiven Zeitintervallen unterschiedlich ist.

9. Audiovorrichtung nach Anspruch 7, wobei der Signalprozessor (201) umfasst:
einen ersten Satz von Filtern (303), die dazu eingerichtet sind, den ersten Satz von Audiosignalen zu filtern, und
einen Kombinierer (303), der dazu eingerichtet ist, Ausgänge des ersten Satzes von Filtern (303) zu kombinieren, um das Strahlformausgangsaudiosignal zu erzeugen;
eine Rückkopplungsschaltung (401), die einen zweiten Satz von Filtern umfasst, die dazu eingerichtet sind, einen zweiten Satz von Audiosignalen aus einer Filterung des Strahlformausgangsaudiosignals zu erzeugen, wobei jedes Filter des zweiten Satzes von Filtern eine Frequenzantwort aufweist, die eine komplexe Konjugation eines Filters des ersten Satzes von Filtern (303) ist;
einen ersten Satz von räumlichen Filtern (301, 601, 701), die dazu eingerichtet sind, eine erste räumliche Filterung auf den ersten Satz von Audiosignalen und/oder den zweiten Satz von Audiosignalen anzuwenden, wobei der erste Satz von räumlichen Filtern (301, 601, 701) Koeffizienten aufweist, die aus Dekorrelationskoeffizienten bestimmt werden, die in den Dekorrelationsparametern enthalten sind;
und wobei
der Strahlformadapter (205) dazu eingerichtet ist, den ersten Satz von Filtern (303) und den zweiten Satz von Filtern als Reaktion auf einen Vergleich des ersten Satzes von Audiosignalen und
des zweiten Satzes von Audiosignalen anzupassen; und der Dekorrelationsadapter (203) dazu eingerichtet ist, Dekorrelationskoeffizienten für einen Satz von räumlichen Dekorrelationsfiltern zu bestimmen, die dekorrelierte Ausgangssignale aus dem ersten Satz von Audiosignalen erzeugen, wobei der Dekorrelationsadapter (203) dazu eingerichtet ist, die Dekorrelationskoeffizienten als Reaktion auf einen Aktualisierungswert anzupassen, der aus dem ersten Satz von Audiosignalen bestimmt wird.

10. Audiovorrichtung nach Anspruch 9, wobei der erste Satz von räumlichen Filtern (301) dazu eingerichtet ist, den ersten Satz von Audiosignalen zu filtern.

11. Audiovorrichtung nach Anspruch 9 oder 10, wobei der erste Satz von Filtern (303) dazu eingerichtet ist, den ersten Satz von Audiosignalen nach dem Filtern durch den ersten Satz von räumlichen Filtern (601) zu filtern, und der Strahlformadapter (205) dazu eingerichtet ist, den Vergleich unter Verwendung des ersten Satzes von Audiosignalen vor dem Filtern durch den ersten Satz von räumlichen Filtern (601) durchzuführen.

12. Audiovorrichtung nach Anspruch 9, wobei der erste Satz von räumlichen Filtern (701) dazu eingerichtet ist, den zweiten Satz von Audiosignalen zu filtern.

13. Audiovorrichtung nach einem der vorhergehenden Ansprüche, wobei der Dekorrelationsadapter (203) dazu eingerichtet ist, die adaptive räumliche Dekorrelation als einen Satz von räumlichen Dekorrelationsfiltern zu bestimmen, wobei jedes Ausgangsaudiosignal eines Filters des Satzes von räumlichen Dekorrelationsfiltern mit einem Eingangsaudiosignal des ersten Satzes von Audiosignalen verknüpft ist, indem die folgenden Schritte durchgeführt werden:
Segmentieren des ersten Satzes von Audiosignalen in Zeitsegmente und, für zumindest einige Zeitsegmente, Durchführen der folgenden Schritte:
Erzeugen einer Frequenz-Bin-Repräsentation des ersten Satzes von Audiosignalen, wobei jedes Frequenz-Bin der Frequenz-Bin-Repräsentation des ersten Satzes von Audiosignalen einen Frequenz-Bin-Wert für jedes der Audiosignale des ersten Satzes von Audiosignalen umfasst;
Erzeugen einer Frequenz-Bin-Repräsentation eines Satzes von Ausgangssignalen, wobei jedes Frequenz-Bin der Frequenz-Bin-Repräsentation des Satzes von Ausgangssignalen einen Frequenz-Bin-Wert für jedes der Ausgangssignale umfasst, wobei der Frequenz-Bin-Wert für ein gegebenes Ausgangssignal des Satzes von Ausgangssignalen für ein gegebenes Frequenz-Bin als eine gewichtete Kombination von Frequenz-Bin-Werten des ersten Satzes von Audiosignalen für das gegebene Frequenz-Bin erzeugt wird, wobei die gewichtete Kombination die Dekorrelationskoeffizienten als Gewichtungen aufweist;
Aktualisieren einer ersten Gewichtung für einen Beitrag zu einem ersten Frequenz-Bin-Wert eines ersten Frequenz-Bins für ein erstes Ausgangssignal, das mit einem ersten Eingangsaudiosignal verknüpft ist, von einem zweiten Frequenz-Bin-Wert des ersten Frequenz-Bins für ein zweites Eingangsaudiosignal, das mit einem zweiten Ausgangssignal verknüpft ist, als Reaktion auf ein Korrelationsmaß zwischen einem ersten vorherigen Frequenz-Bin-Wert des ersten Ausgangssignals für das erste Frequenz-Bin und einem zweiten vorherigen Frequenz-Bin-Wert des zweiten Ausgangssignals für das erste Frequenz-Bin.

14. Audiovorrichtung nach Anspruch 13, wobei der Dekorrelationsadapter (203) dazu eingerichtet ist, die erste Gewichtung als Reaktion auf ein Produkt eines ersten Werts und eines zweiten Werts zu aktualisieren, wobei der erste Wert entweder der erste vorherige Frequenz-Bin-Wert oder der zweite vorherige Frequenz-Bin-Wert ist und der zweite Wert eine komplexe Konjugation des anderen des ersten vorherigen Frequenz-Bin-Werts oder des zweiten vorherigen Frequenz-Bin-Werts ist.

15. Betriebsverfahren für eine Audiovorrichtung, wobei das Verfahren umfasst:
Empfangen eines ersten Satzes von Audiosignalen, wobei der erste Satz von Audiosignalen Audiosignale umfasst, die Audio einer Szene von verschiedenen Positionen erfassen;
Erzeugen eines Strahlformausgangsaudiosignals aus dem ersten Satz von Audiosignalen, wobei das Erzeugen des Strahlformausgangsaudiosignals umfasst:
Erzeugen des Strahlformausgangsaudiosignals aus einer Signalverarbeitung des ersten Satzes von Audiosignalen, wobei die Signalverarbeitung räumliche Strahlformung und adaptive räumliche Dekorrelation für den ersten Satz von Audiosignalen beinhaltet, wobei die adaptive räumliche Dekorrelation von einem Satz von Dekorrelationsparametern abhängt und die räumliche Strahlformung von einem Satz von Strahlformparametern abhängt, wobei die Strahlformung eine Kombination von Audiosignalen beinhaltet, wobei die Kombination das Strahlformausgangsaudiosignal erzeugt und eine Filterung und/oder eine Gewichtung der Audiosignale beinhaltet, wobei die Strahlformparameter Parameter sind, die die Filterung und/oder die Gewichtung von Audiosignalen der Kombination beschreiben;
Anpassen des Satzes von Dekorrelationsparametern in Abhängigkeit von dem ersten Satz von Audiosignalen;
Anpassen des Satzes von Strahlformparametern in Abhängigkeit von dem Strahlformausgangsaudiosignal; und
Anwenden einer Frequenzentzwerrung auf das Strahlformausgangsaudiosignal, um ein Ausgangssignal zu erzeugen; **gekennzeichnet durch**:
Anpassen der Frequenzentzerrung in Abhängigkeit vom Satz von Strahlformparametern.

16. Computerprogrammprodukt, umfassend Computerprogrammcodemittel, die dazu eingerichtet sind, alle Schritte nach Anspruch 15 durchzuführen, wenn das Programm auf einem Computer ausgeführt wird.

## Revendications

1. Appareil audio comprenant :
un récepteur (101) conçu pour recevoir un premier ensemble de signaux audio, le premier ensemble de signaux audio comprenant des signaux audio capturant l'audio d'une scène à partir de positions différentes ;
un formateur de faisceau audio (103) conçu pour générer un signal audio de sortie de forme de faisceau à partir du premier ensemble de signaux audio, le formateur de faisceau audio (103) comprenant :
un processeur de signal (201) conçu pour générer le signal audio de sortie de forme de faisceau à partir d'un traitement de signal du premier ensemble de signaux audio, le traitement du signal comportant une formation de faisceau spatiale et une décorrélation spatiale pour le premier ensemble de signaux audio, la décorrélation spatiale dépendant d'un ensemble de paramètres de décorrélation et la formation de faisceau spatiale dépendant d'un ensemble de paramètres de formation de faisceau, la formation de faisceau comprenant une combinaison de signaux audio, la combinaison générant le signal audio de sortie de forme de faisceau et comportant au moins l'un parmi un filtrage et une pondération des signaux audio, les paramètres de forme de faisceau étant des paramètres décrivant au moins l'un parmi le filtrage et la pondération de signaux audio de la combinaison ;
un adaptateur de forme de faisceau (205) conçu pour adapter l'ensemble de paramètres de forme de faisceau en fonction du signal audio de sortie de forme de faisceau ; et
un égaliseur (105) conçu pour appliquer une égalisation fréquentielle au signal audio de sortie de forme de faisceau afin de générer un signal de sortie ;
**caractérisé par** :
un adaptateur d'égalisation (107) conçu pour adapter l'égalisation fréquentielle en fonction de l'ensemble de paramètres de forme de faisceau.

2. Appareil audio selon la revendication 1, dans lequel l'adaptateur d'égalisation (107) est conçu pour adapter l'égalisation fréquentielle en fonction de l'ensemble de paramètres de décorrélation.

3. Appareil audio selon la revendication 1, dans lequel le processeur de signal (201) comprend :
un décorrélateur spatial (301) conçu pour recevoir le premier ensemble de signaux audio et pour générer un premier ensemble décorrélé de signaux audio en exécutant la décorrélation spatiale ; et
un circuit de forme de faisceau (303) conçu pour effectuer la formation de faisceau spatiale en combinant le premier ensemble décorrélé de signaux audio, la combinaison dépendant de l'ensemble de paramètres de forme de faisceau.

4. Appareil audio selon l'une quelconque des revendications précédentes, dans lequel l'adaptateur d'égalisation (107) est conçu pour adapter l'égalisation fréquentielle pour avoir une réponse en fréquence de phase minimale.

5. Appareil audio selon l'une quelconque des revendications précédentes, dans lequel l'adaptateur d'égalisation (107) est conçu pour adapter l'égalisation fréquentielle pour avoir une réponse en fréquence passe-bas.

6. Appareil audio selon l'une quelconque des revendications précédentes, dans lequel l'adaptateur d'égalisation (107) est conçu pour passer d'une première égalisation fréquentielle à une deuxième égalisation fréquentielle en déterminant des premiers échantillons intermédiaires du signal de sortie pour la première égalisation fréquentielle et des deuxièmes échantillons intermédiaires du signal de sortie pour la deuxième égalisation fréquentielle, et en générant des échantillons du signal de sortie sous la forme d'une combinaison pondérée des premiers échantillons intermédiaires et des deuxièmes échantillons intermédiaires, l'adaptateur d'égalisation (107) étant conçu pour modifier progressivement la pondération relative des premiers échantillons intermédiaires et des deuxièmes échantillons intermédiaires pendant un intervalle de temps de transition.

7. Appareil audio selon la revendication 1, dans lequel la décorrélation spatiale est une décorrélation spatiale adaptative et l'appareil audio comprend en outre :
un adaptateur de décorrélation (203) conçu pour adapter l'ensemble de paramètres de décorrélation en fonction du premier ensemble de signaux audio.

8. Appareil audio selon la revendication 7, comprenant en outre un détecteur audio (801) conçu pour déterminer un ensemble d'intervalles de temps actifs pendant lesquels une source audio est active et un ensemble d'intervalles de temps inactifs pendant lesquels la source audio n'est pas active ; et où au moins l'une de l'adaptation de l'ensemble des paramètres de forme de faisceau et de l'adaptation de l'ensemble des paramètres de décorrélation (203) est différente pour l'ensemble des intervalles de temps actifs et l'ensemble des intervalles de temps inactifs.

9. Appareil audio selon la revendication 7, dans lequel le processeur de signal (201) comprend :
un premier ensemble de filtres (303) conçu pour filtrer le premier ensemble de signaux audio, et
un combineur (303) conçu pour combiner les sorties du premier ensemble de filtres (303) pour générer le signal audio de sortie de forme de faisceau ;
un circuit de rétroaction (401) comprenant un deuxième ensemble de filtres conçu pour générer un deuxième ensemble de signaux audio à partir d'un filtrage du signal audio de sortie de forme de faisceau, chaque filtre du deuxième ensemble de filtres ayant une réponse en fréquence étant un conjugué complexe d'un filtre du premier ensemble de filtres (303) ;
un premier ensemble de filtres spatiaux (301, 601, 701) conçu pour appliquer un premier filtrage spatial à l'un au moins du premier ensemble de signaux audio et du deuxième ensemble de signaux audio, le premier ensemble de filtres spatiaux (301, 601, 701) ayant des coefficients déterminés à partir de coefficients de décorrélation compris dans les paramètres de décorrélation ;
et où
l'adaptateur de forme de faisceau (205) est conçu pour adapter le premier ensemble de filtres (303) et le deuxième ensemble de filtres en réponse à une comparaison du premier ensemble de signaux audio et
du deuxième ensemble de signaux audio ; et l'adaptateur de décorrélation (203) est conçu pour déterminer des coefficients de décorrélation pour un ensemble de filtres de décorrélation spatiale générant des signaux de sortie décorrélés à partir du premier ensemble de signaux audio, l'adaptateur de décorrélation (203) étant conçu pour adapter les coefficients de décorrélation en réponse à une valeur de mise à jour déterminée à partir du premier ensemble de signaux audio.

10. Appareil audio selon la revendication 9, dans lequel le premier ensemble de filtres spatiaux (301) est conçu pour filtrer le premier ensemble de signaux audio.

11. Appareil audio selon la revendication 9 ou la revendication 10, dans lequel le premier ensemble de filtres (303) est conçu pour filtrer le premier ensemble de signaux audio après filtrage par le premier ensemble de filtres spatiaux (601), et l'adaptateur de forme de faisceau (205) est conçu pour effectuer la comparaison en utilisant le premier ensemble de signaux audio avant filtrage par le premier ensemble de filtres spatiaux (601).

12. Appareil audio selon la revendication 9, dans lequel le premier ensemble de filtres spatiaux (701) est conçu pour filtrer le deuxième ensemble de signaux audio.

13. Appareil audio selon l'une quelconque des revendications précédentes, dans lequel l'adaptateur de décorrélation (203) est conçu pour déterminer la décorrélation spatiale adaptative en tant qu'ensemble de filtres de décorrélation spatiale, chaque signal audio de sortie d'un filtre de l'ensemble de filtres de décorrélation spatiale étant lié à un signal audio d'entrée du premier ensemble de signaux audio, en exécutant les étapes suivantes :
segmenter le premier ensemble de signaux audio en segments temporels et, pendant au moins certains segments temporels, exécuter les étapes suivantes :
générer une représentation par compartiments fréquentiels du premier ensemble de signaux audio, chaque compartiment fréquentiel de la représentation par compartiments fréquentiels du premier ensemble de signaux audio comprenant une valeur de compartiment fréquentiel pour chacun des signaux audio du premier ensemble de signaux audio ;
générer une représentation par compartiments fréquentiels d'un ensemble de signaux de sortie, chaque compartiment fréquentiel de la représentation par compartiments fréquentiels de l'ensemble de signaux de sortie comprenant une valeur de compartiment fréquentiel pour chacun des signaux de sortie, la valeur de compartiment fréquentiel pour un signal de sortie donné de l'ensemble de signaux de sortie pour un compartiment fréquentiel donné étant générée comme une combinaison pondérée de valeurs de compartiment fréquentiel du premier ensemble de signaux audio pour le compartiment fréquentiel donné, la combinaison pondérée ayant comme poids les coefficients de décorrélation ;
mettre à jour un premier poids pour une contribution à une première valeur de compartiment fréquentiel d'un premier compartiment fréquentiel pour un premier signal de sortie lié à un premier signal audio d'entrée à partir d'une deuxième valeur de compartiment fréquentiel du premier compartiment fréquentiel pour un deuxième signal audio d'entrée lié à un deuxième signal de sortie en réponse à une mesure de corrélation entre une première valeur de compartiment fréquentiel précédente du premier signal de sortie pour le premier compartiment fréquentiel et une deuxième valeur de compartiment fréquentiel précédente du deuxième signal de sortie pour le premier compartiment fréquentiel.

14. Appareil audio selon la revendication 13, dans lequel l'adaptateur de décorrélation (203) est conçu pour mettre à jour le premier poids en réponse à un produit d'une première valeur et d'une deuxième valeur, la première valeur étant l'une de la première valeur de compartiment fréquentiel précédente et de la deuxième valeur de compartiment fréquentiel précédente, et la deuxième valeur de compartiment fréquentiel précédente étant un conjugué complexe de l'autre valeur parmi la première valeur de compartiment fréquentiel précédente et la deuxième valeur de compartiment fréquentiel précédente.

15. Procédé de fonctionnement pour un appareil audio, le procédé comprenant les étapes suivantes :
recevoir un premier ensemble de signaux audio, le premier ensemble de signaux audio comprenant des signaux audio capturant l'audio d'une scène à partir de positions différentes ;
générer un signal audio de sortie de forme de faisceau à partir du premier ensemble de signaux audio, où la génération du signal audio de sortie de forme de faisceau comprend les étapes suivantes :
générer le signal audio de sortie de forme de faisceau à partir d'un traitement de signal du premier ensemble de signaux audio, le traitement du signal comportant une formation de faisceau spatiale et une décorrélation spatiale adaptative pour le premier ensemble de signaux audio, la décorrélation spatiale adaptative dépendant d'un ensemble de paramètres de décorrélation et la formation de faisceau spatiale dépendant d'un ensemble de paramètres de formation de faisceau, la formation de faisceau comprenant une combinaison de signaux audio, la combinaison générant le signal audio de sortie de forme de faisceau et comportant au moins l'un parmi un filtrage et une pondération des signaux audio, les paramètres de forme de faisceau étant des paramètres décrivant au moins l'un parmi le filtrage et la pondération de signaux audio de la combinaison ;
adapter l'ensemble de paramètres de décorrélation en fonction du premier ensemble de signaux audio.
adapter l'ensemble de paramètres de forme de faisceau en fonction du signal audio de sortie de forme de faisceau ;
et
appliquer une égalisation fréquentielle au signal audio de sortie de forme de faisceau afin de générer un signal de sortie ; **caractérisé par** :
l'adaptation de l'égalisation fréquentielle en fonction de l'ensemble des paramètres de forme de faisceau.

16. Produit programme informatique comprenant un moyen de code de programme informatique conçu pour exécuter toutes les étapes de la revendication 15 lorsque ledit programme est exécuté sur un ordinateur.
